(19) Europäisches Patentamt / European Patent Office / Office européen des brevets

(11) **EP 4 570 867 B1**

(12) **EUROPEAN PATENT SPECIFICATION**


(45) Date of publication and mention of the grant of the patent:
**15.04.2026 Bulletin 2026/16**

(21) Application number: **23216256.0**

(22) Date of filing: **13.12.2023**

(51) International Patent Classification (IPC):
***C09D 11/101*** *(2014.01)* ***C07F 9/53*** *(2006.01)*
***C08F 2/50*** *(2006.01)* ***C08F 2/48*** *(2006.01)*
***C08K 5/5397*** *(2006.01)* ***G03F 7/029*** *(2006.01)*

(52) Cooperative Patent Classification (CPC):
**C09D 11/101; C07F 9/5337; C08F 2/48; C08F 2/50; G03F 7/029;** C08K 5/5397


(54) **ACYL PHOSPHINE OXIDE PHOTOINITIATORS**

ACYLPHOSPHINOXID-PHOTOINITIATOREN

PHOTOINITIATEURS À BASE D'OXYDE D'ACYL PHOSPHINE


(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(43) Date of publication of application:
**18.06.2025 Bulletin 2025/25**



(73) Proprietor: **AGFA NV**
**2640 Mortsel (BE)**

(72) Inventors:
- **LOCCUFIER, Johan**
  **2640 Mortsel (BE)**
- **HUYSECOM, Luc**
  **2640 Mortsel (BE)**

(74) Representative: **Strijckers, Hans Louis P.**
**AGFA NV**
**Intellectual Property Department**
**Septestraat 27**
**2640 Mortsel (BE)**



(56) References cited:
**WO-A1-2015/181332** **WO-A1-2019/243039**
**WO-A1-2022/106099**



Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).


EP 4 570 867 B1

## Description

## Technical Field

The present invention relates to photoinitiators including multiple acyl phosphine oxide moieties, and their use in photocurable compositions, such as UV curable varnishes and (inkjet) inks.

## Background Art

Photopolymerization is used in many applications such as inks, adhesive optoelectronics, varnishes and coatings, dental applications, microelectronics, and 3D printing. The light source for the photopolymerization technology is evolving from energy-hungry mercury lamps to the safer light-emitting diodes (LEDs). The majority of UV LEDs operate at 395 nm, but the number of industrially available photoinitiators suitable for curing at such wavelength is rather limited.

A combination of thioxanthones and amine-based co-initiators gives high curing speed, but results in considerable yellowing of the cured layers, making it fit for use in many CMYK printing applications, but not for varnishes and white inks, and sometimes also not for cyan and magenta inks.

Acyl phosphine oxides have found to be very suitable for 395 nm LED curing without these photo-yellowing problems. However, the number of industrially available acyl phosphine oxides is limited and there are increasing concerns on their toxicology. The applicability of bis-acyl phosphine oxides is often limited by their solubility in UV curable formulations, leading to mono-acyl phosphine oxides as particularly preferred photoinitiators for 395 nm radiation curable compositions, further narrowing the options.

On top of the toxicological concerns and limitations in formulation latitude, as good as all available acyl phosphine oxide initiators are prone to migration and generate volatile degradation products, leading to smell. Especially smell is the limiting factor for a lot of large volume applications such as indoor decoration. The application scope further widens if on top the migration problem can be solved.

Over the last decade, there has been a considerable research activity in search of alternatives for the industrially available acyl phosphine oxides, targeting at solving the above-mentioned problems.

Functionalization on the mesityl fragment of acyl phosphine oxide photoinitiators as disclosed in WO 2014/051026 (FUJIFILM) , WO 2014/129213 (FUJIFILM) , WO 2019/243039 (AGFA) and WO 2022/106099 (AGFA) is a potential solution to solve the problem of volatile degradation products.

WO 2019/243039 (AGFA) discloses urea and oxalyl amide functionalized acyl phosphine oxides, where additional supramolecular interactions are used to further control volatility of the degradation products.

In WO 2022/106099 (AGFA) , additional tertiary amines are integrated into the structure to further optimize the surface cure of the printed images, avoiding migratability of skin irritating acrylates. However, the use of supramolecular interactions often limits the formulation latitude which had to be controlled by additional structural elements not having any further function for radiation curing. This leads to an increase in molecular weight per photoinitiating moiety, impacting both the viscosity of the formulation and the curing speed for a same weight ratio in the formulation. For maintaining the curing speed on an acceptable level, higher amounts of the photoinitiator have to be added further impacting the viscosity. The impact on viscosity limits the applicability of the disclosed photoinitiators in ink jet applications, where viscosity of the formulation is particularly critical.

Therefore, there is still a need for photoinitiators having a high photoreactivity and formulation latitude without generating smell and without significantly impacting the viscosity of the formulations.

## Summary of invention

Now it has been found that the above-mentioned problems can be largely solved by a photoinitiator including multiple monoacyl phosphine oxide moieties wherein the monoacyl phosphine oxide moieties are linked to each other via their acyl group (and thus not via the phosphine oxide group) and that at least 2 monoacyl phosphine oxide moieties have a chemical structure differing in the phosphine oxide part.

A bis-acyl phosphine oxide is capable of generating two radical species upon UV exposure, but is often limited by solubility in UV curable formulations. The acyl phosphine oxide photoinitiator of the invention are also capable of generating two radical species and exhibit good solubility. The crystallization of the photoinitiator according to the invention is reduced by using monoacyl phosphine oxide moieties having a chemical structure differing in the phosphine oxide part. It is believed that using chemically different monoacyl phosphine oxide moieties impedes the stacking into a crystal.

Another advantage of the photoinitiators according to the invention is that they allow to prepare low odor photocurable compositions. An acyl phosphine oxide photoinitiator generates upon UV exposure two radical species: a phosphine oxide radical and an acyl radical. While the phosphine oxide radical is almost completely incorporated into the

polymerizing network, this is not the case for the acyl radical. Unreacted acyl radicals usually form aldehydes, such as mesitaldehyde, causing a bad smell of the cured product. By linking the monoacyl phosphine oxide moieties to each other via their acyl group, the molecular weight of the acyl radical increases, thus reducing the volatile degradation products of the acyl phosphine oxide photoinitiators. Another aspect is that also the probability of incorporation into the polymerizing network increases as one photoinitiator generates multiple acyl radicals that are linked to each other. The latter is beneficial for solving the migration problem.

A surprising improvement in surface curability was also observed when monoacyl phosphine oxide moieties having a chemical structure differing in the phosphine oxide part were used in the photoinitiator compared to photoinitiators having identical monoacyl phosphine oxide moieties. Acyl phosphine oxide photoinitiators generally exhibit good curability for the internal part of a polymerizable layer, but not for the surface part of the polymerizable layer leading to an undesired tackiness. The photoinitiators of the invention exhibit a surface curability that is comparable or even better than the monoacyl phosphine oxide photoinitiators TPO and TPO-L that are generally used by industry.

It is thus an object of the present invention to provide a new class of acyl phosphine oxides with increased formulation latitude for low odor photocurable compositions and exhibiting good surface curing.

It is a further object of the present invention to provide a mixture of acyl phosphine oxide based photoinitiators, wherein at least one of the photoinitiators in the mixture is a photoinitiator according to the present invention.

It is an even further object of the present invention to provide a radiation curable composition, such as a UV curable ink, comprising at least one photoinitiator according to the present invention.

Use of a photoinitiator according to the invention improves the surface curing of a photocurable composition and/or reduces the smell of a cured product of a photocurable composition, when compared to photocurable compositions including photoinitiators generally used by industry.

These and other objects and advantages of the present invention will become apparent from the detailed description given below.

## Description of embodiments

Definitions

The term "alkyl" means all variants possible for each number of carbon atoms in the alkyl group, i.e. for one carbon atom: methyl, for two carbon atoms: ethyl, for three carbon atoms: n-propyl and isopropyl; for four carbon atoms: n-butyl, isobutyl and tertiary-butyl; for five carbon atoms: n-pentyl, 1,1-dimethyl-propyl, 2,2-dimethylpropyl and 2-methyl-butyl, etc.

The term "substituted" in e.g. substituted alkyl group means that the alkyl group may be substituted by other atoms than the atoms normally present in such a group, i.e. carbon and hydrogen. For example, a substituted alkyl group may include a halogen atom or a thiol group, while an unsubstituted alkyl group contains only carbon and hydrogen atoms.

Unless otherwise specified a substituted alkyl group is preferably substituted by a constituent selected from the group consisting of an aryl group, a heteroaryl group, an ester group, an amide group, an ether group, a thioether group, a ketone group, an aldehyde group, a sulfoxide group, a sulfone group, a sulfonate ester group, a sulphonamide group, -Cl, -Br, -I, - OH, -SH, -CN and -$NO_2$.

Unless otherwise specified a substituted or unsubstituted alkyl group is preferably a $C_1$ to $C_6$-alkyl group.

Unless otherwise specified a substituted or unsubstituted alkenyl group is preferably a $C_2$ to $C_6$-alkenyl group.

Unless otherwise specified a substituted or unsubstituted alkynyl group is preferably a $C_2$ to $C_6$-alkynyl group.

Unless otherwise specified a substituted or unsubstituted alkoxy-group is preferably a $C_1$ to $C_6$-alkyl group, wherein a methoxy group, an ethoxy group and a propoxy group are particularly preferred.

The term aryl group means a monocyclic- or polycyclic aromatic ring structure comprising only carbon atoms in the ring structure.

Unless otherwise specified an aryl group is preferably a phenyl or a naphthyl group that may include one, two, three or more $C_1$ to $C_6$-alkyl groups, which may be substituted alkyl groups.

Unless otherwise specified a substituted aryl group is an aryl group including one or more groups selected from an aldehyde group, -Cl, -Br, -I, -OH, -SH, -CN and -$NO_2$.

The term heteroaryl group means a monocyclic- or polycyclic aromatic ring comprising carbon atoms and one or more heteroatoms in the ring structure, preferably 1 to 4 heteroatoms, independently selected from nitrogen, oxygen, selenium and sulphur. Preferably, a heteroaryl group is a monocyclic ring, and more preferably a heteroaryl group is a five- or six-membered ring substituted by one, two or three oxygen atoms, nitrogen atoms, sulphur atoms, selenium atoms or combinations thereof.

Preferred examples of heteroaryl groups include, but are not limited to, pyridinyl, pyridazinyl, pyrimidyl, pyrazyl, quinolyl, triazinyl, pyrrolyl, pyrazolyl, imidazolyl, (1,2,3,)- and (1,2,4)-triazolyl, pyrazinyl, pyrimidinyl, tetrazolyl, furyl, thienyl, isoxazolyl, thiazolyl, isoxazolyl, and oxazolyl.

Photoinitiators

A photoinitiator in accordance with the invention includes 2 to 6, preferably 2 to 4, more preferably 2 or 3 and most preferably 2 monoacyl phosphine oxide moieties, wherein the monoacyl phosphine oxide moieties are linked to each other via their acyl group and wherein at least 2 monoacyl phosphine oxide moieties have a chemical structure differing in the phosphine oxide part.

The photoinitiator preferably has a structure according to Formula (1):

$[A]_y$- L - $[B]_x$ Formula (1),

wherein

x and y independently represent an integer from 1 to 3;
L represents an x+y-valent linking group having no more than 25 carbon atoms;
A represents an acyl phosphine oxide moiety according to Formula (1-1):

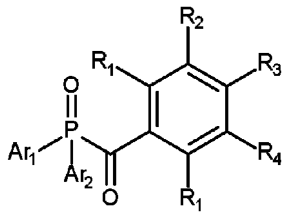

Formula (1-1),

wherein $Ar_1$ and $Ar_2$ independently represent a substituted or unsubstituted aryl or heteroaryl group; $R_1$ is selected from the group consisting of a substituted or unsubstituted alkyl group, a substituted or unsubstituted aryl group and a substituted or unsubstituted alkoxy-group;
$R_2$, $R_3$ and $R_4$ are independently selected from the group consisting of the coupling position to L or a substituent selected from the group consisting of a hydrogen, a substituted or unsubstituted alkyl group, a substituted or unsubstituted alkenyl group, a substituted or unsubstituted alkynyl group, a substituted or unsubstituted alkoxy group and a substituted or unsubstituted aryl or heteroaryl group;
B represents an acyl phosphine oxide moiety according to Formula (1-2):

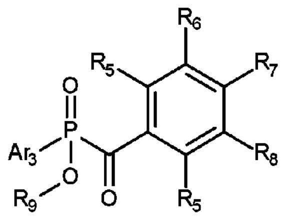

Formula (1-2),

wherein $Ar_3$ represent a substituted or unsubstituted aryl or heteroaryl group; $R_5$ is selected from the group consisting of a substituted or unsubstituted alkyl group, a substituted or unsubstituted aryl group and a substituted or unsubstituted alkoxy-group; $R_6$, $R_7$ and $R_8$ are independently selected from the group consisting of the coupling position to L or a substituent selected from the group consisting of a hydrogen, a substituted or unsubstituted alkyl group, a substituted or unsubstituted alkenyl group, a substituted or unsubstituted alkynyl group, a substituted or unsubstituted alkoxy group and a substituted or unsubstituted aryl or heteroaryl group;
$R_9$ represents a substituted or unsubstituted alkyl group, a substituted or unsubstituted alkenyl group, a substituted or unsubstituted alkynyl group and a substituted or unsubstituted aryl or heteroaryl group.

In a preferred embodiment of the photoinitiator according to Formula (1), x and y independently represent an integer from 1 to 2 and in an even more preferred embodiment x and y are both equal to 1. With x and y equal to 1, a further improved solubility in the photocurable composition is observed.

In a preferred embodiment, the ratio of molecular weight between A and B on the one hand and L on the other hand meets the following equation (Eq-1):

$$(x * Mw(A) + y * Mw(B))/ Mw(L) \geq 1.5 \quad \text{(Eq-1)}.$$

In a more preferred embodiment, this ratio is 2 or larger. In the most preferred embodiment this ratio is 2.5 or larger. When the photoinitiator according to the invention complies with these equations, excellent formulation latitude is obtained since low impact on viscosity and good solubility in the radiation curable composition is observed.

In a preferred embodiment of the photoinitiator according to Formula (1), the linking group L comprises no more than 15 carbon atoms. In the most preferred embodiment L comprises no more than 12 carbon atoms. With such linking groups, again excellent formulation latitude is obtained since low impact on viscosity and good solubility in the radiation curable composition is observed.

The molecular weight of the photoinitiator according to Formula (1) is preferably between 700 and 2,500 g/mole, more preferably between 750 and 2,000 g/mole, and most preferably between 800 and 1,500 g/mole. In these ranges, the photoinitiator according to Formula (1) can be suitably used in conventional amounts in UV curable inkjet inks without impacting the viscosity of the ink too much.

In a preferred embodiment of the photoinitiator according to Formula (1), L comprises at least one ether function or a tertiary amine group. Surprisingly a higher curing sensitivity was generally observed when the linking group L contained at least one ether function or a tertiary amine group.

In a preferred embodiment of the photoinitiator according to Formula (1), the linking group L may be composed of one or more fragments selected from the group consisting of $-CH_2-$, $-CHMe-$, $-CMe_2-$, $-O-CH_2-CH_2-$, $-CH_2-O-CH_2-$, $-O-CH_2-CH_2-O-$, and $-C(=O)-CH_2-CH_2-C(=O)-$; wherein the fragments may occur multiple times in the linking group L.

In a preferred embodiment of the photoinitiator according to Formula (1), A represents an acyl phosphine oxide moiety with $Ar_1$ and $Ar_2$ representing a phenyl group, $R_1$ and $R_3$ representing a methyl group, $R_2$ representing hydrogen, and $R_4$ representing the coupling position to L; and/or B represents an acyl phosphine oxide moiety with $Ar_3$ representing a phenyl group, $R_5$ and $R_7$ representing a methyl group; $R_6$ representing hydrogen, $R_8$ representing the coupling position to L, and $R_9$ representing an ethyl group.

The above preferred embodiments may be combined with each other without any limitation.

In a further preferred embodiment, the photoinitiator according to Formula (1) with x and y representing the integer 1 is part of a mixture of photoinitiators, wherein the mixture comprises the photoinitiators according to Formula (1-a), Formula (1-b), and Formula (1-c) with the groups A, B and L as defined as for the photoinitiator according to Formula (1), wherein

Formula (1-a) is A-L-B, Formula (1-b) is A-L-A, and Formula (1-c) is B-L-B. The mixture preferably comprises between 20 and 80 mol% of the photoinitiator according to Formula (1-a), more preferably the mixture contains at least 30 mol% and most preferably at least 40 mol% of the photoinitiator according to Formula (1-a). In these ranges, an improved surface cure of inkjet printed images has been observed compared to A-L-A or B-L-B.

In a further preferred embodiment, the photoinitiator according to the present invention is a photoinitiator according to Formula (2):

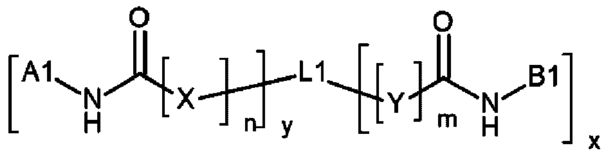

Formula (2),

wherein

- n and m independently represent 0 or 1;
- x and y independently represent an integer from 1 to 3;
- L1 represents an (x+y)-valent linking group having no more than 25 carbon atoms;
- X and Y independently represent O or NH;
- A1 represents an acyl phosphine oxide moiety according to Formula (2-1):

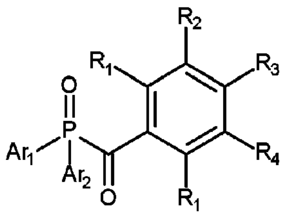

Formula (2-1),

wherein $Ar_1$ and $Ar_2$ independently represent a substituted or unsubstituted aryl or heteroaryl group; $R_1$ is selected from the group consisting of a substituted or unsubstituted alkyl group, a substituted or unsubstituted aryl group and a substituted or unsubstituted alkoxy-group;

$R_2$, $R_3$ and $R_4$ are independently selected from the group consisting of the coupling position to N or a substituent selected from the group consisting of a hydrogen, a substituted or unsubstituted alkyl group, a substituted or unsubstituted alkenyl group, a substituted or unsubstituted alkynyl group, a substituted or unsubstituted alkoxy group and a substituted or unsubstituted aryl or heteroaryl group;

B1 represents an acyl phosphine oxide moiety according to Formula (2-2):

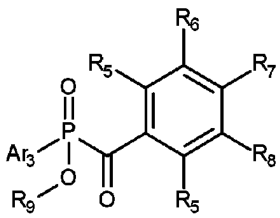

Formula (2-2),

wherein $Ar_3$ represent a substituted or unsubstituted aryl or heteroaryl group; $R_5$ is selected from the group consisting of a substituted or unsubstituted alkyl group, a substituted or unsubstituted aryl group and a substituted or unsubstituted alkoxy-group; $R_6$, $R_7$ and $R_8$ are independently selected from the group consisting of the coupling position to N or a substituent selected from the group consisting of a hydrogen, a substituted or unsubstituted alkyl group, a substituted or unsubstituted alkenyl group, a substituted or unsubstituted alkynyl group, a substituted or unsubstituted alkoxy group and a substituted or unsubstituted aryl or heteroaryl group;

$R_9$ represents a substituted or unsubstituted alkyl group, a substituted or unsubstituted alkenyl group, a substituted or unsubstituted alkynyl group and a substituted or unsubstituted aryl or heteroaryl group.

In a preferred embodiment of the photoinitiator according to Formula (2), n and m are 0 and x and y independently represent an integer from 1 to 2. In the most preferred embodiment, n and m are 0 and x and y are equal to 1. With x and y equal to 1, an improved solubility in the photocurable composition is observed.

In a preferred embodiment of the photoinitiator according to Formula (2), the linking group L1 comprises no more than 15 carbon atoms. In the most preferred embodiment L1 comprises no more than 12 carbon atoms. With such linking groups, excellent formulation latitude is obtained since low impact on viscosity and good solubility in the radiation curable composition is observed.

In a preferred embodiment of the photoinitiator according to Formula (2), L1 comprises at least one ether function or a tertiary amine group. Surprisingly a higher curing sensitivity was generally observed that when the linking group L contained at least one ether function or a tertiary amine group.

In a preferred embodiment of the photoinitiator according to Formula (2), the linking group L1 may be composed of one or more fragments selected from the group consisting of $-CH_2-$ , -CHMe- , $-CMe_2-$ , $-O-CH_2-CH_2-$ , $-CH_2-O-CH_2-$ , $-O-CH_2-CH_2-O-$ , and $-C(=O)-CH_2-CH_2-C(=O)-$ ; wherein the fragments may occur multiple times in the linking group L1.

In a preferred embodiment of the photoinitiator according to Formula (2), A represents an acyl phosphine oxide moiety with $Ar_1$ and $Ar_2$ representing a phenyl group, $R_1$ and $R_3$ representing a methyl group, $R_2$ representing hydrogen, and $R_4$ representing the coupling position to N; and/or B represents an acyl phosphine oxide moiety with $Ar_3$ representing a phenyl group, $R_5$ and $R_7$ representing a methyl group; $R_6$ representing hydrogen, $R_8$ representing the coupling position to L, and $R_9$ representing an ethyl group.

The above preferred embodiments may be combined with each other without any limitation.

In a further preferred embodiment, the photoinitiator according to Formula (2) with x and y representing the integer 1 is part of a mixture of photoinitiators, wherein the mixture comprises the photoinitiators according to Formula (2-a), Formula (2-b), and Formula (2-c) with the groups A' being $A-NH-C(=O)-(X)_n-$, B' being $B-NH-C(=O)-(Y)_m-$, and L1 as defined as for the photoinitiator according to Formula (2), wherein Formula (2-a) is A'-L1-B', Formula (2-b) is A'-L1-A', and

Formula (2-c) is B' -L1-B'. The mixture preferably comprises between 20 and 80 mol% of the photoinitiator according to Formula (2-a), more preferably the mixture contains at least 30 mol% and most preferably at least 40 mol% of the photoinitiator according to Formula (2-a). In these ranges, an improved surface cure of inkjet printed images has been observed compared to using only A'-L1-A' or B'-L1-B'.

Preferred examples of the photoinitiators according to the present invention are given below in Table 1 without being limited thereto.

**Table 1**

| | |
|---|---|
| | ASYM-1 |
| 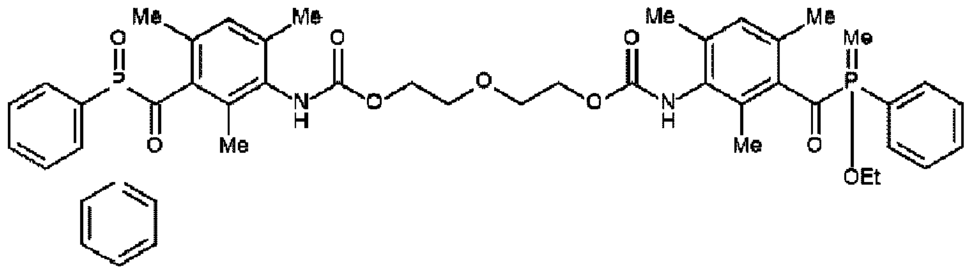 | |
| 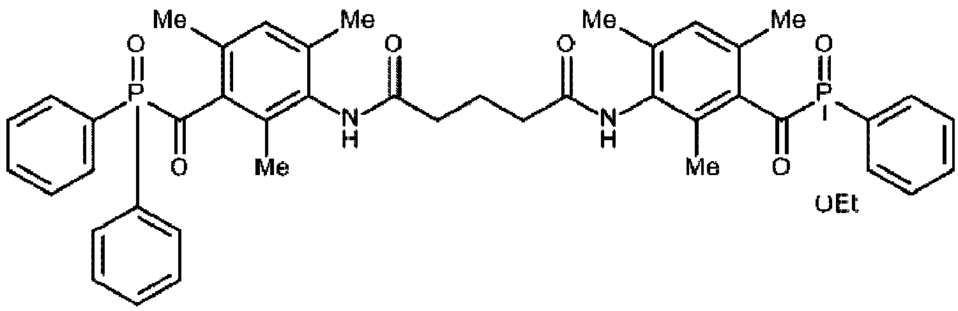 | ASYM-2 |
| 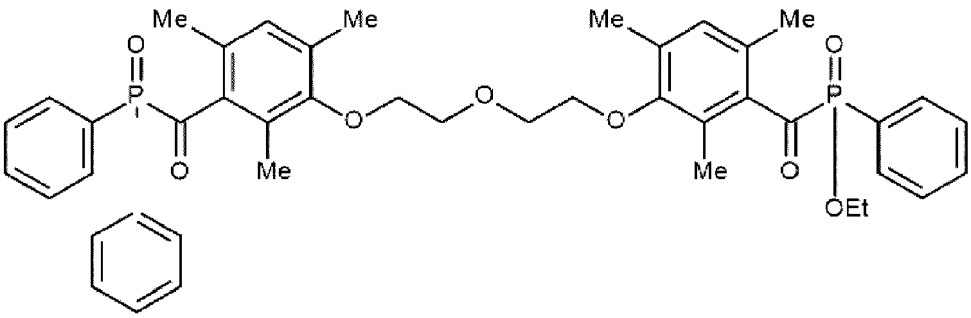 | ASYM-3 |
| 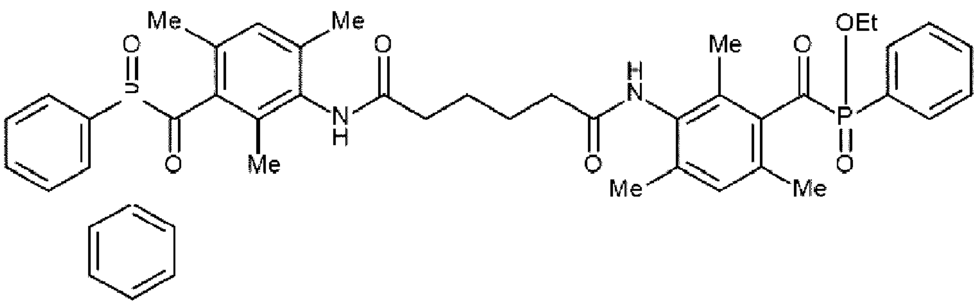 | ASYM-4 |
| | ASYM-5 |

(continued)

| | |
|---|---|
| 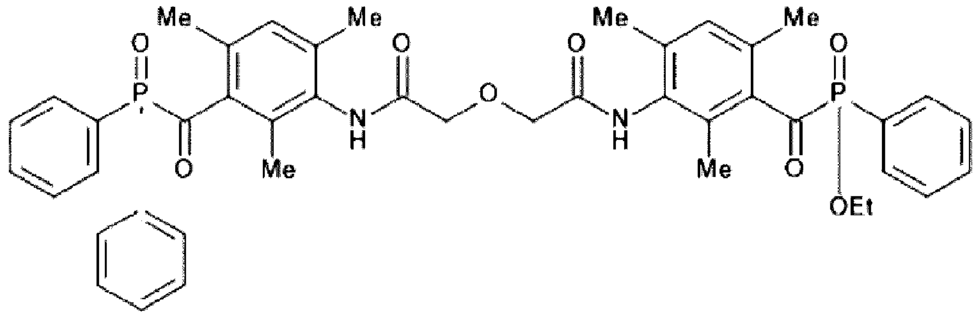 | |
| 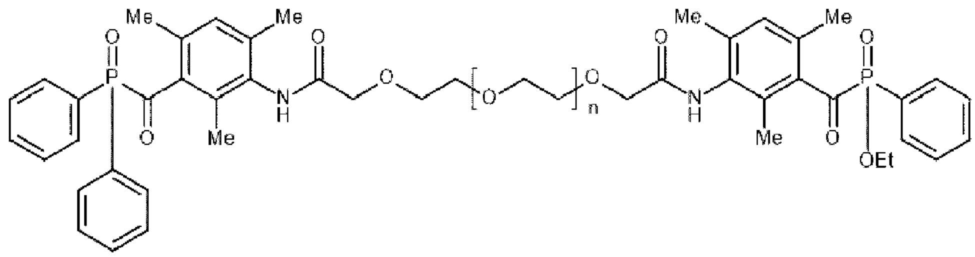<br>n=2 on average | ASYM-6 |
| 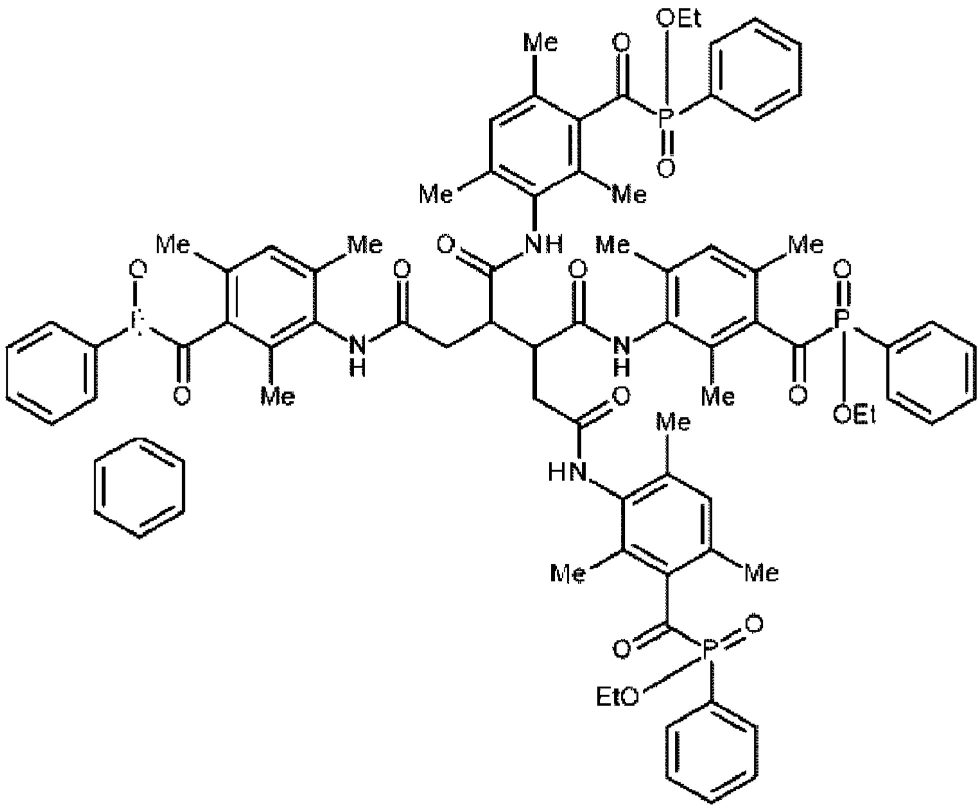 | ASYM-7 |
| | ASYM-8 |

(continued)

| | |
|---|---|
| 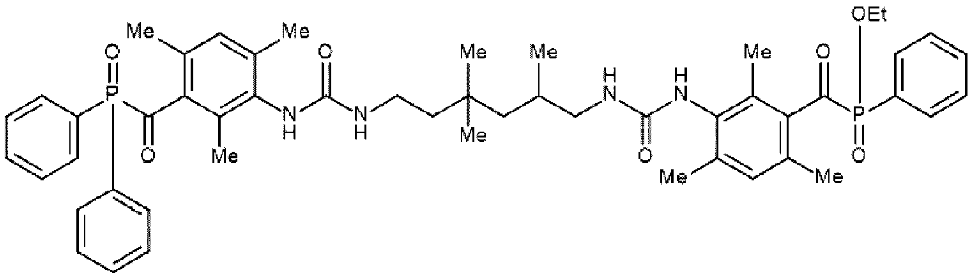 | |
| 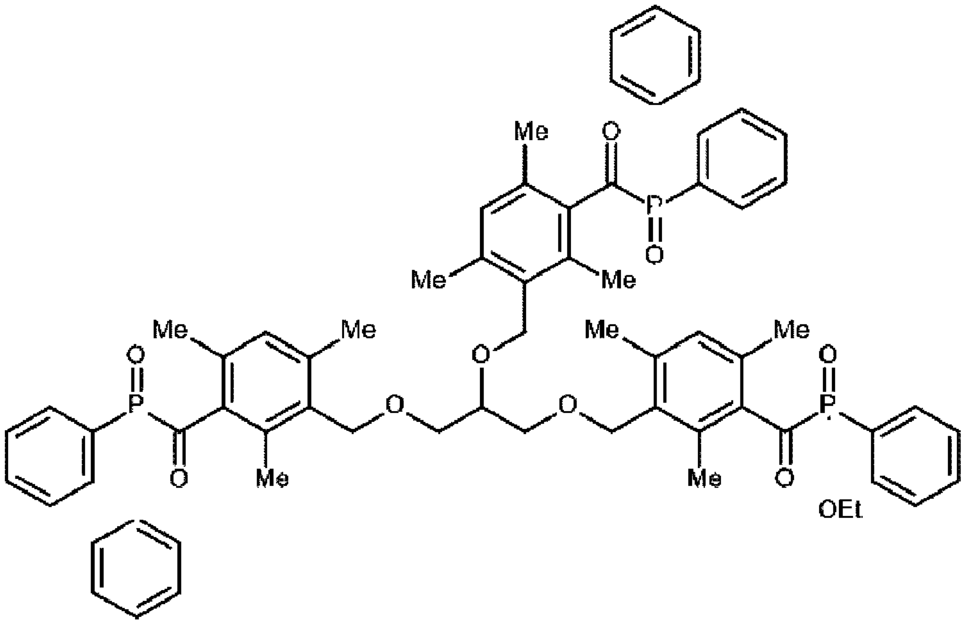 | ASYM-9 |
| 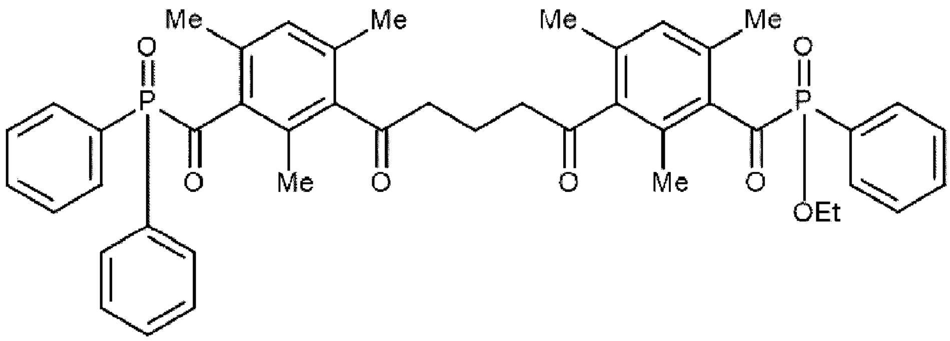 | ASYM-10 |
| | ASYM-11 |

(continued)

| | |
|---|---|
| 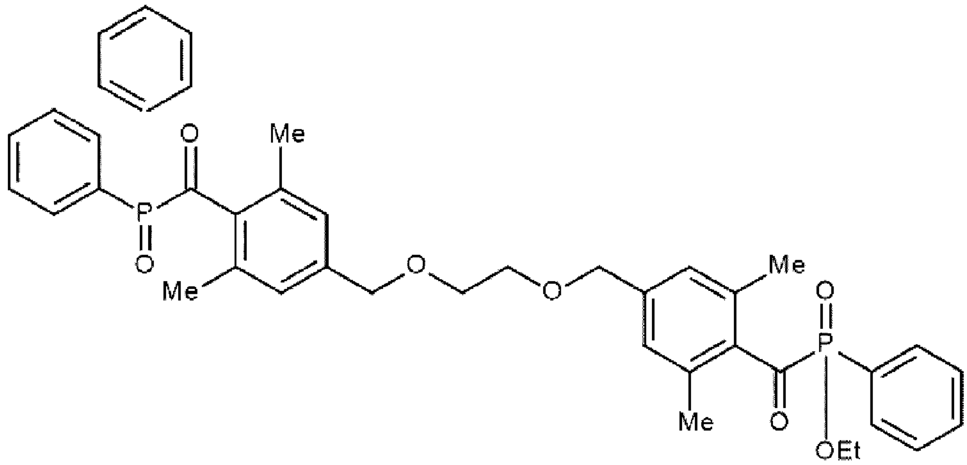 | |
| 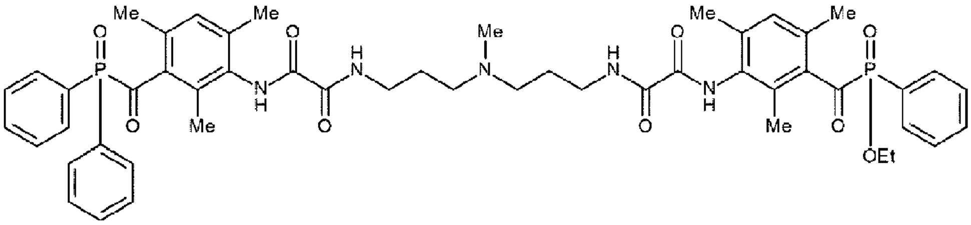 | ASYM-12 |
| 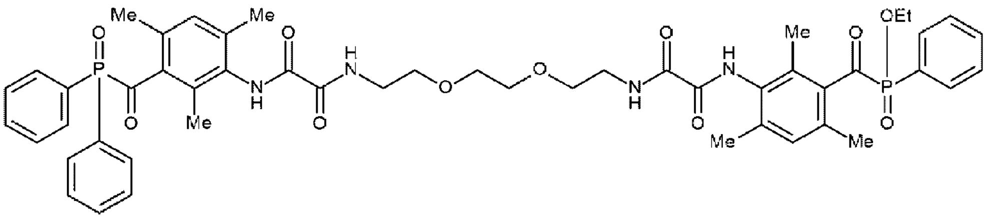 | ASYM-13 |

In another preferred embodiment the photoinitiator in accordance with the invention includes 2 to 6, preferably 2 to 4, more preferably 2 or 3 and most preferably 2 monoacyl phosphine oxide moieties, wherein the monoacyl phosphine oxide moieties are linked to each other via their acyl group by a linking group, wherein at least 2 monoacyl phosphine oxide moieties have a chemical structure differing in the phosphine oxide part, and wherein the linking group includes a free radical polymerizable group. The free radical polymerizable group results in a polymerizable photoinitiator.

The free radical polymerizable group is preferably selected from the group consisting of an acrylate, a methacrylate, an acrylamide, a methacrylamide, a styrene group, a maleate, a fumarate, an itaconate, a vinyl ether, a vinyl ester, an allyl ether and an allyl ester. In a preferred embodiment, the free radical polymerizable group is selected from the group consisting of an acrylate and a methacrylate, an acrylate being particularly preferred.

The advantage of the linking group including a polymerizable group is that it further increases the likelihood that the acyl group containing degradation products after UV curing are integrated into the polymerized network and do not cause migration problems or bad smell.

Preferred examples of the polymerizable photoinitiators according to the present invention are given below in Table 2 without being limited thereto.

**Table 2**

| | |
|---|---|
| 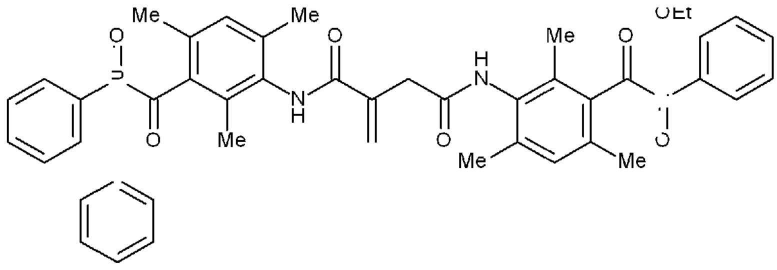 | PA-1 |
| 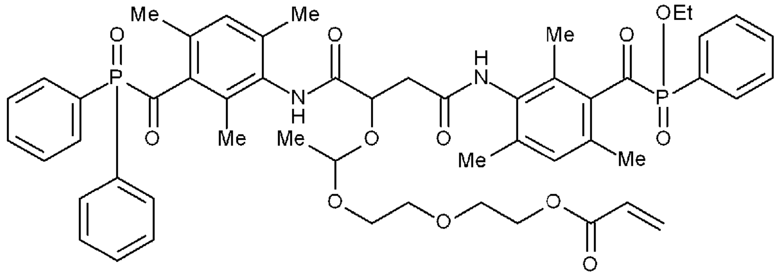 | PA-2 |
| 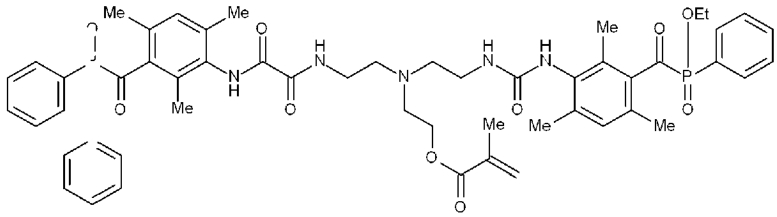 | PA-3 |
| 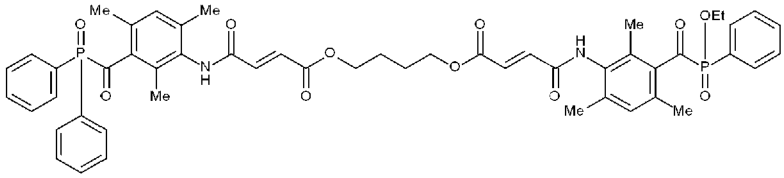 | PA-4 |

Photocurable Compositions

A photocurable composition in accordance with the invention comprises a photoinitiator as described above and a free radical polymerizable compound as essential components.

Any monomer, oligomer and polymer capable of free radical polymerization may be used as free radical polymerizable compound. The polymerizable compounds may be any monomer and/or oligomer found in the Polymer Handbook Vol 1 + 2, 4th edition, edited by J. BRANDRUP et al., Wiley-Interscience, 1999. A combination of monomers and oligomers may also be used. The monomers and oligomers may possess different degrees of functionality, and a mixture including combinations of mono-, di-, tri-and higher functionality monomers and oligomers may be used.

There is also no limitation on the type of free radical polymerizable chemistry used in the photocurable composition. The free radical polymerizable chemistry may be a (meth)acrylate based polymerizable chemistry, but can also be a thiol-ene and/or thiol-yne polymerizable chemistry. As water and organic solvents may be present, it may also be a polymerizable polymeric particle, such as a polymerizable latex.

The radiation curable composition may include other photoinitiators, which may be a Norrish type I initiator and/or a Norrish type II initiator. A Norrish Type I initiator is an initiator which cleaves after excitation, yielding the initiating radical immediately. A Norrish type II-initiator is a photoinitiator which is activated by actinic radiation and forms free radicals by hydrogen abstraction from a second compound that becomes the actual initiating free radical. This second compound is called a polymerization synergist or a co-initiator. Suitable photo-initiators are disclosed in CRIVELLO, J.V., et al. VOLUME III: Photoinitiators for Free Radical Cationic . 2nd edition. Edited by BRADLEY, G.. London,UK: John Wiley and Sons Ltd, 1998. p.287-294.

In order to increase the photosensitivity further, the free radical curable composition may additionally contain one or more co-initiators, also called polymerization synergists, for which usually amine synergists are used.

Suitable examples of amine synergists can be categorized in three groups:

1) tertiary aliphatic amines such as methyldiethanolamine, dimethylethanolamine, triethanolamine, triethylamine and N-methylmorpholine;
(2) aromatic amines such as amylparadimethylaminobenzoate, 2-n-butoxyethyl-4-(dimethylamino) benzoate, 2-(dimethylamino)ethylbenzoate, ethyl-4-(dimethylamino)benzoate, and 2-ethylhexyl-4-(dimethylamino)benzoate; and
(3) (meth)acrylated amines such as dialkylamino alkyl(meth)acrylates (e.g., diethylaminoethylacrylate) or N-morpholinoalkyl-(meth)acrylates (e.g., N-morpholinoethyl-acrylate).

Another preferred embodiment is a photocurable (inkjet) ink comprising the photocurable composition in accordance with the invention. The (inkjet) ink preferably contains a colorant, more preferably a colour pigment.
A photocurable composition or a photocurable (inkjet) ink in accordance with the invention preferably comprises the photoinitiator of the invention in an amount of 1 to 25 wt%, more preferably 2 to 20 wt%, based on the total weight of the photocurable composition or ink.
The photocurable composition or a photocurable (inkjet) ink may contain other additives, such as surfactants, dispersants, dispersion synergists, stabilizers, UV absorbers and the like.

Cured Products

Another aspect of the invention is a cured product formed by UV LED curing the photocurable composition in accordance with the invention. The cured product exhibits an improvement in the amount of migrateables and a reduction in bad smell compared to photocurable compositions including the traditionally used acyl phosphine oxides TPO and TPO-L

Manufacturing Methods

A manufacturing method of a photoinitiator mixture including a photoinitiator according to the invention includes the steps of:

a) mixing 2 monoacyl phosphine oxide compounds having a chemical structure differing in the phosphine oxide part and each having attached to the acyl part a primary amine group or a group according to Formula (M-1) in a molar ratio of 3:1 to 1:3; and
b) reacting the 2 monoacyl phosphine oxide compounds with a compound linking the 2 monoacyl phosphine oxide compounds via the primary amine group or the group according to Formula (M-1);

wherein the group according to Formula (M-1) is:

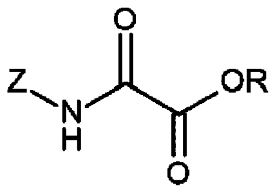
Formula (M-1),

wherein Z represents a carbon atom of an aromatic ring in the acyl part, and R represents a $C_1$ to $C_6$-alkyl group, preferably an ethyl group.

Preferred monoacyl phosphine oxide compounds having attached to the acyl part a primary amine group are ethyl P-(3-amino-2,4,6-trimethylbenzoyl)-P-phenylphosphinate and 3-[(diphenylphosphinyl)carbonyl]-2,4,6-trimethylbenzenamine.

**EXAMPLES**

Methods

1. TLC-MS

The molecular mass was determined using TLC-MS, according to the following procedure. A TLC was run under circumstances given in the synthetic examples. The TLC was analyzed using a CAMAG™ TLC-MS interface coupled to an

AmaZon™ SL mass spectrometer (supplied by BRUKER DALTONICS) via an Agilent™ 1100 HPLC pump. First a blank spectrum was taken by eluting a spot on the TLC plate where no compounds are present with a 0.01 molar solution of ammonium acetate in methanol. A second spectrum of the compound to be analyzed was taken by eluting the spot of the compound under consideration with a 0.01 molar solution of ammonium acetate in methanol. The first spectrum was subtracted from the second spectrum, giving the spectrum of the compound to be analyzed.

2. Curability

The photocurable compositions were coated on a PET175 substrate using a bar coater and a 20 μm wired bar. The samples were cured on a Aktiprint™ mini duo LED curing station at full power and a linear curing speed of 10m/min. The number of passes to get full cure, including surface cure was taken as measure for curing speed, with a maximum of 10 passes. For good curability, preferably no more than 3 passes are required.

The surface cure was checked by wiping the surface of the cured samples five times with a Q-tip according to Table 3.

**Table 3**

| Score Surface cure | Observation |
|---|---|
| **0** | no visual damage |
| **1** | a change in surface gloss |
| **2** | clear surface damage |
| **3** | the coating damaged |
| **4** | almost full removal of the coating |
| **5** | coating was completely removed upon wiping |

3. Smell

The smell was evaluated by two persons directly after UV LED curing in the curability test and comparing it with the sample containing TPO (2,4,6-trimethylbenzoyldiphenyl phosphine oxide, CASRN75980-60-8).

The evaluation was performed by giving a score according to the following criteria in Table 4

**Table 4**

| Score Smell | Criterion |
|---|---|
| **Not Improved** | No improved smell is discernible compared to the sample containing TPO |
| **Improved** | An improved smell is discernible compared to the sample |
| | containing TPO |

4. Average Particle Size

The average particle size of the pigment particles was determined by photon correlation spectroscopy at a wavelength of 633 nm with a 4mW HeNe laser on a diluted sample of the pigment dispersion. The particle size analyzer used was a Malvern™ nano-S available from Goffin-Meyvis. The sample was prepared by addition of one drop of the dispersion to a cuvet containing 1.5 mL ethyl acetate and mixed until a homogenous sample was obtained. The measured particle size is the average value of 3 consecutive measurements consisting of 6 runs of 20 seconds.

Materials

All materials used in the following examples were readily available from standard sources such the Sigma-Aldrich (MERCK) and Acros Organics (THERMOFISHER SCIENTIFIC) unless otherwise specified. Any water used was demineralized water.

**Amino-TPO-L** is Ethyl P-(3-amino-2,4,6-trimethylbenzoyl)-P-phenylphosphinate (CASRN2143083-29-6) was prepared according to the method described in WO 2017/191043 (AGFA GRAPHICS) .

**Amino-TPO** is 3-[(diphenylphosphinyl)carbonyl]-2,4,6-trimethylbenzenamine (CASRN2771298-79-2) was prepared according to the method described in WO 2022/106100 (AGFA) .

**TPO-oxam** (CASRN2771298-80-5) is a TPO derivative having the following structure and has been prepared according to paragraph [0082] of WO 2022/106099 (AGFA) :

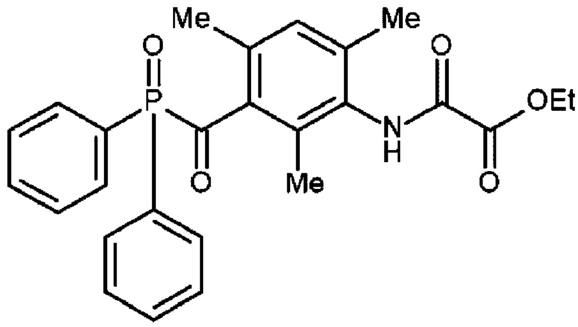

.

**TPO-L-oxam** (CASRN2404565-44-0) is a TPO-L derivative having the following structure and has been prepared according to paragraph [0220] of WO 2019/243039 (AGFA) :

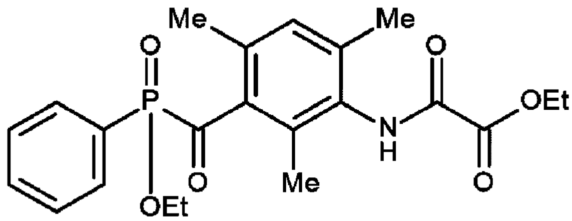

.

**Diethyleneglycol bis(chloroformate)** was supplied by ABCR GmbH.

**Adipoylchloride, 3,3,5-trimethyl-hexamethylene-1,6-diisocyante, bis(3-aminopropyl)methyl amine** were supplied by TCI Europe.

**3,6-dioxa-1,8-octane diamine** was supplied by Aldrich.

**Glutaroyl dichloride** and **diglycoloyl dichloride** were supplied by TCI Europe.

**TPO** (CASRN75980-60-8) was supplied by IGM as Omnirad™ TPO

**TPO-L** (CASRN84434-11-7) was supplied by IGM as Omnirad™ TPO-L.

**Silwet™ L7500** is a silicone based wetting agent supplied by Momentive Performance Materials GmbH.

**Genomer™ 2253** is an acrylated amine oligomer supplied by Rahn.

**VEEA** is 2-(2-vinyloxyethoxy)ethyl acrylate, a difunctional monomer available from NIPPON SHOKUBAI, Japan.

**DPGDA** is dipropylene glycol diacrylate available as Sartomer™ SR508 from ARKEMA.

**PET175** is a 175 pm thick unsubbed polyethylene terephthalate sheet available as Astera™ type UR175.334 from AGFA-GEVAERT NV.

**Comparative photoinitiator COMPINI-1** was prepared as follows:

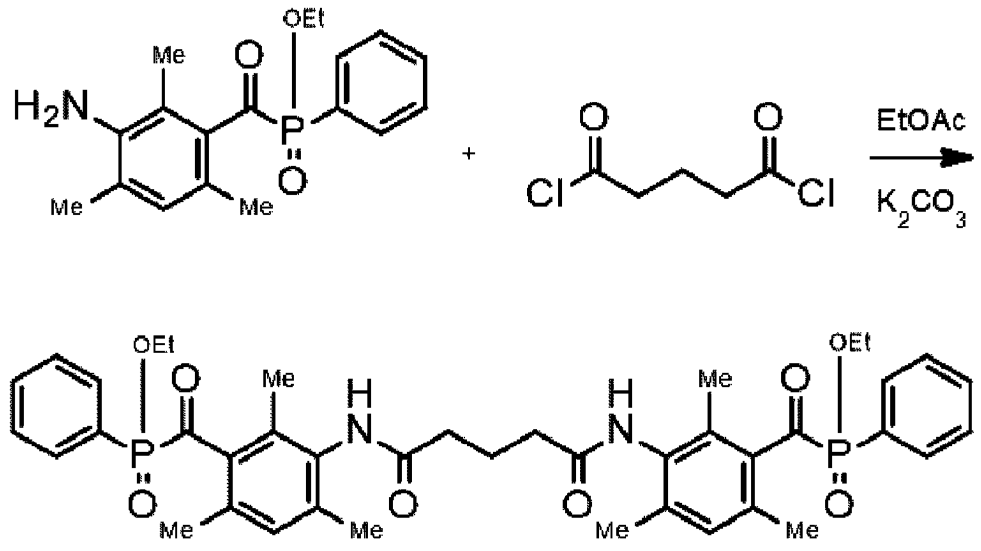


6.63 g (20 mmol) amino-TPO-L was dissolved in 40 ml ethyl acetate. A solution of 3.3 g (24 mmol) potassium carbonate in 50 ml water was added to the ethyl acetate solution of amino-TPO-L upon which ethyl P-(3-amino-2,4,6-trimethylbenzoyl)-P-phenylphosphinate completely dissolved. The reaction mixture was cooled to 5°C and 1.74 g (10.3 mmol) glutaryl dichloride was added dropwise over five minutes while vigorously stirring the mixture. The temperature was maintained below 10°C during the addition. The cooling was removed and the reaction was allowed to continue for two hours at room temperature. The ethyl acetate phase was isolated, extracted with 50 ml of a 0.5 M sodium chloride solution in water and dried over $MgSO_4$ upon which COMPINI-1 started to crystallize from the medium. The $MgSO_4$ was removed by adding 400 ml water. The undissolved COMPINI-1 was isolated and treated with 200 ml isopropyl acetate for one hour. Upon treating the residue with isopropyl acetate, COMPINI-1 gradually crystallized from the medium and was isolated by filtration as a white crystalline compound. 4 g (y : 53 %) of COMPINI-1 was isolated (m.p. : 132°C, TLC analysis on a TLC Silica gel 60 RP-18 $F_{254}$S plate supplied by MERCK, eluent MeOH/0.5 M NaCl : 70/30, $R_f$: 0.21). The structure of COMPINI-1 was further confirmed using TLC-MS.

**Comparative photoinitiator COMPINI-2** was prepared as follows:

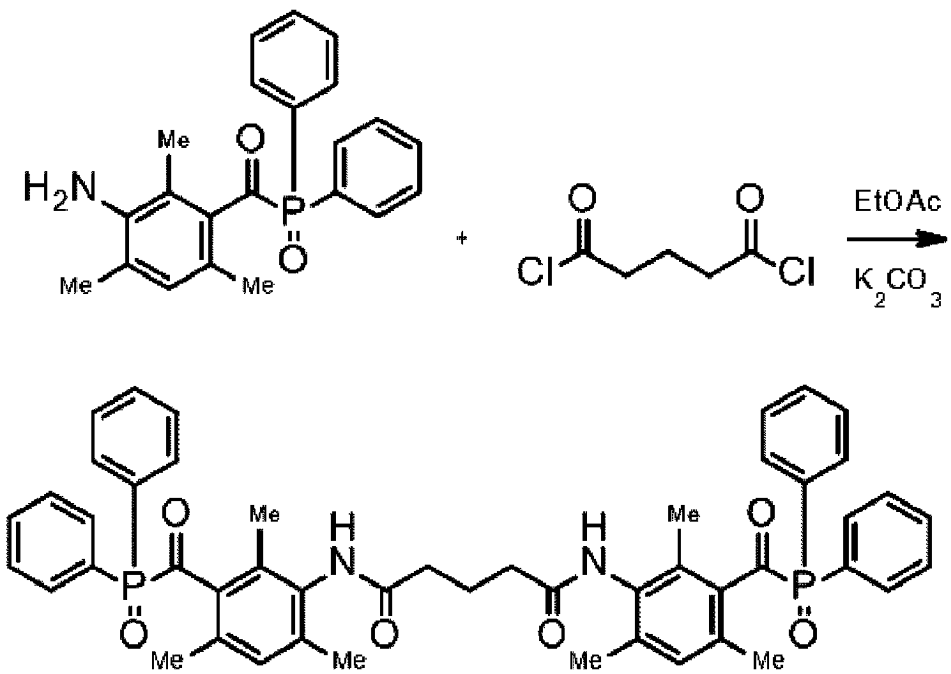


7.27 g (20 mmol) amino-TPO was dissolved in 40 ml ethyl acetate. A solution of 3.3 g (24 mmol) potassium carbonate in 50 ml water was added to the ethyl acetate solution of amino-TPO upon which amino-TPO completely dissolved in the ethyl acetate. The reaction mixture was cooled to 10°C and 1.74 g (10.3 mmol) glutaryl dichloride was added dropwise over five

minutes while vigorously stirring the mixture. The temperature was maintained below 12°C during the addition. The cooling was removed and the reaction was allowed to continue for one hour at room temperature. COMPINI-3 crystallized from the medium and was isolated by filtration. The crystallized COMPINI-3 was washed with ethyl acetate and dried. 5.9 g (y : 67 %) of COMPINI-2 was isolated (m.p. : 158°C, TLC analysis on a TLC Silica gel 60 $F_{254}$ plate supplied by MERCK , eluent : methylene chloride/methanol 95/5, $R_f$ : 0.14).

**Comparative photoinitiator COMPINI-3** was prepared as follows:

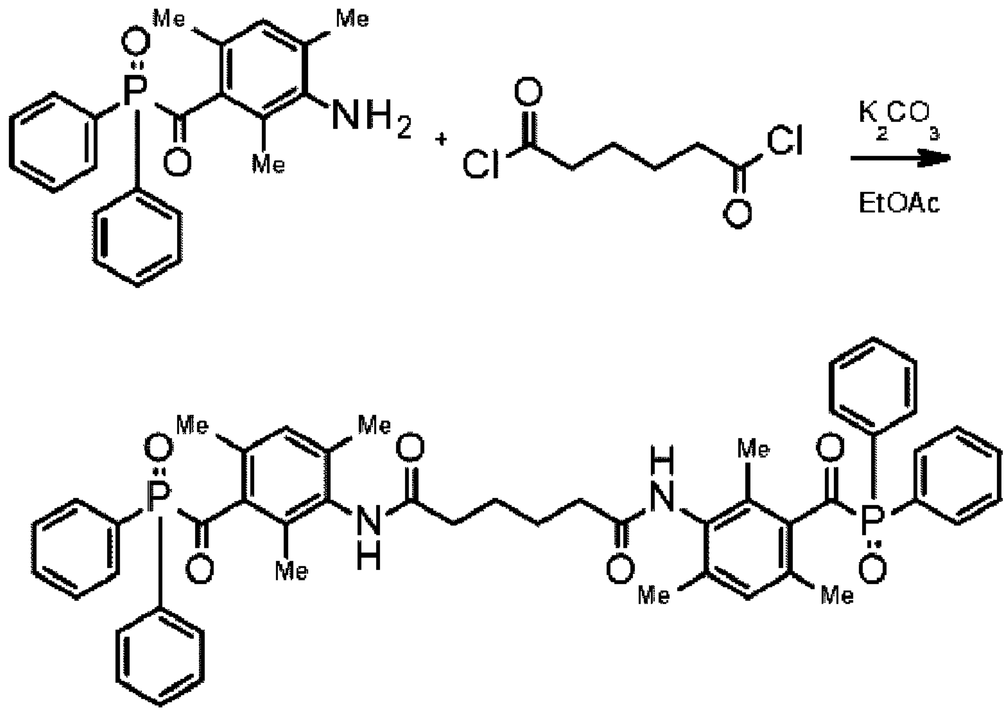


7.27 g (20 mmol) amino-TPO was added to 40 ml ethyl acetate. A solution of 2.9 g (21 mmol) potassium carbonate in 20 ml water was added and the reaction mixture was stirred. 1.92 g (10.2 mmol) adipoylchloride was added over 3 minutes upon which the temperature rose to 29°C. The reaction was allowed to continue for 16 hours at room temperature. COMPINI-3 was isolated by filtration, washed with 50 ml ethyl acetate and dried. 8.4 g (y : 100 %) of COMPINI-3 was isolated (TLC analysis on a Uniplate™ Analtech HPTL-RP18F plate supplied by MILES SCIENTIFIC : eluent MeOH/0.5 M NaCl 70/30, $R_f$ : 0.1).

**Comparative photoinitiator COMPINI-4** was prepared as follows:

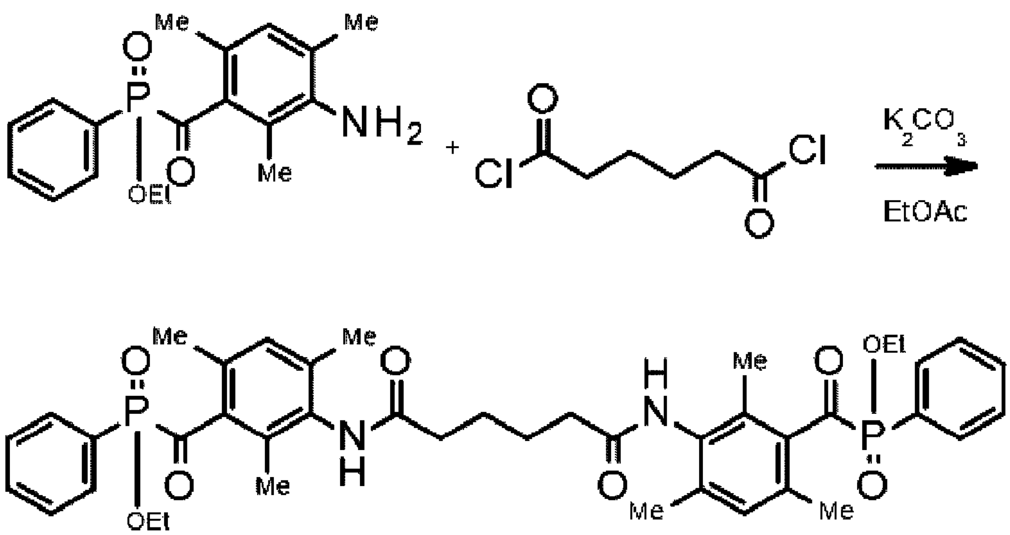


6.63 g (20 mmol) amino-TPO-L was added to 40 ml ethyl acetate. A solution of 2.9 g (21 mmol) potassium carbonate in 20

ml water was added and the reaction mixture was stirred. 1.92 g (10.2 mmol) adipoylchloride was added over 3 minutes upon which the temperature rose to 32°C. The reaction was allowed to continue for 2 hours. An additional 0.5 g (2.7 mmol) adipoylchloride was added and the reaction was allowed to continue for 30 minutes. The organic fraction was isolated, washed with 40 ml of a 0.5 M sodium chloride solution and evaporated under reduced pressure. 7.4 g (y : 96 %) of COMPINI-4 was isolated (TLC analysis on a Uniplate™ Analtech HPTL-RP18F plate supplied by MILES SCIENTIFIC : eluent MeOH/0.5 M NaCl 70/30, $R_f$ : 0.25)

**PB15:4** is an abbreviation used for Sunfast™ Blue 15:4, a C.I. Pigment Blue 15:4 pigment from SUN CHEMICAL CORPORATION.

**DB162** is an abbreviation used for the polymeric dispersant Disperbyk™ 162 available from BYK CHEMIE GMBH whereof the solvent mixture of 2-methoxy-1-methylethylacetate, xylene and n-butylacetate was removed. The polymeric dispersant is a polyester-polyurethane dispersant on the basis of caprolactone and toluene diisocyanate having an amine value of 13 mg KOH/g, a Mn of about 4,425 and an Mw of about 6,270.

**INHIB** is a mixture forming a polymerization inhibitor having a composition according to Table 5:

**Table 5**

| Component | wt% |
|---|---|
| DPGDA | 82.4 |
| p-methoxyphenol | 4.0 |
| BHT | 10.0 |
| Cupferron™ AL | 3.6 |

**BHT** is an abbreviation for 2,6-di-tert.butyl-4-methylphenol (CASRN128-30-0) from ALDRICH CHEMICAL Co.

**Cupferron™ AL** is aluminium N-nitrosophenylhydroxylamine from WAKO CHEMICALS LTD.

**Example 1**

This example illustrates the synthesis of photoinitiators in accordance with the invention.

Synthesis of INIMIX-1 comprising ASYM-2

3.31 g (10 mmol) amino-TPO-L and 3.63 g (10 mmol) amino-TPO were added to 40 ml ethyl acetate. A solution of 3.3 g (24 mmol) potassium carbonate in 40 ml water was added upon which the acyl phosphine oxides completely dissolved. A solution of 1.74 g (10.3 mmol) glutaroyl dichloride in 5 ml ethyl acetate was added over five minutes, while vigorously stirring. The temperature was maintained below 25°C. The reaction was allowed to continue for one hour at room temperature. The reaction mixture was analyzed using TLC (TLC Silicagel 60 $F_{254}$ supplied by MERCK, eluent : ethyl acetate, $R_f$ (amino-TPO) : 0.25, $R_f$(amino-TPO L) : 0.43). An additional 0.17 g (1 mmol) glutaroyl dichloride was added and the reaction mixture was allowed to continue for 16 hours at room temperature. The organic fraction was isolated, extracted with 40 ml of a 0.5 M NaCl solution in water, dried over $MgSO_4$ and evaporated under reduced pressure. The residual amino-TPO and amino-TPO-L were removed by preparative column chromatography on a Graceresolve™ 80 g SiOH 40 μm 60Å column, using a gradient elution from methylene chloride to methylene chloride/methanol 95/5. 4 g (y : 51%) of INIMIX-1 was isolated (TLC analysis on Uniplate™ Analtech HPTLC-RP18F plate supplied by MILES SCIENTIFIC : eluent MeOH/0.5 M NaCl 70/30, $R_f$ symmetrical-TPO-L : 0.27, $R_f$ ASYM-2 : 0.19, $R_f$ symmetrical-TPO : 0.13). The structure of ASYM-2 was confirmed using TLC-MS.

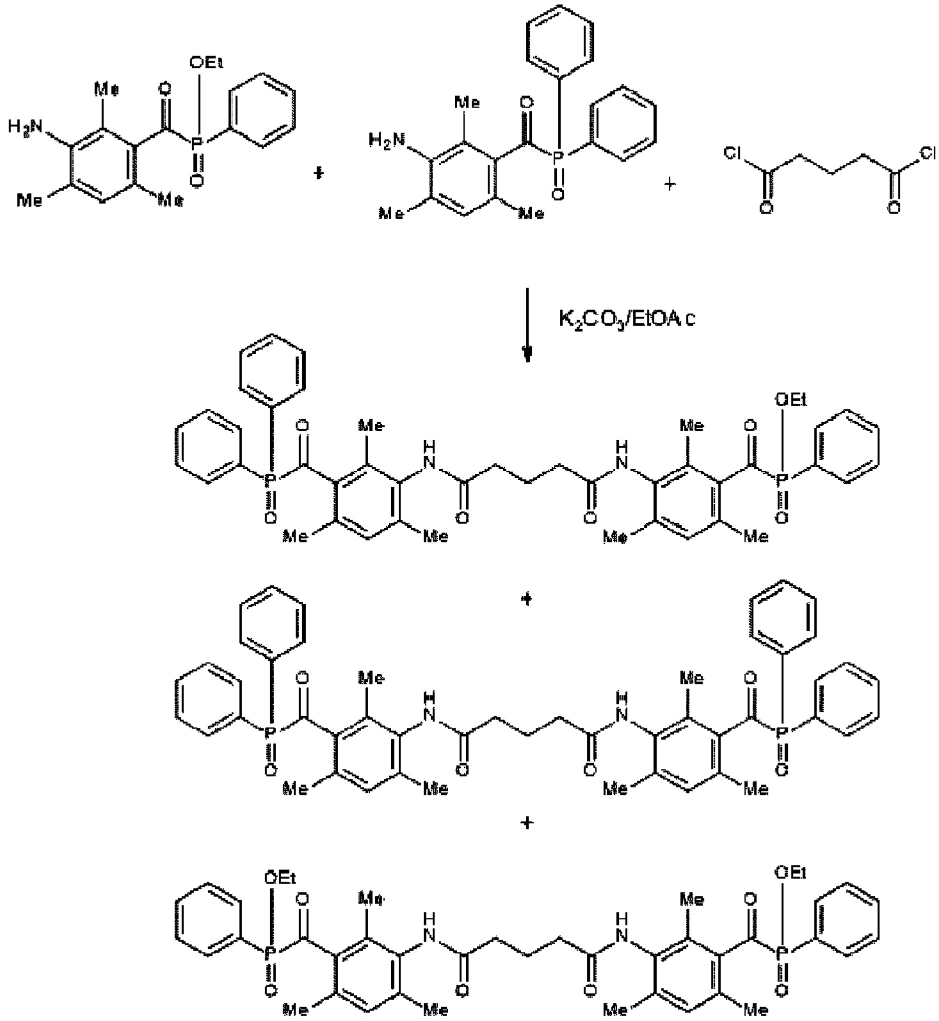


Synthesis of INIMIX-2, INIMIX-3 and INIMIX-4 comprising ASYM-5

Table 6

| Sample | x g amino-TPO | y g amino-TPO-L | yield |
|---|---|---|---|
| INIMIX-2 | 3.63 g (10 mmol) | 3.31 g (10 mmol) | 7.6 g (96 %) |
| INIMIX-3 | 5.45 g (15 mmol) | 1.66 g (5 mmol) | 6.5 g (82 %) |
| INIMIX-4 | 1.82 g (5 mmol) | 4.97 g (15 mmol) | 7.5 g (95 %) |

x g amino-TPO L and y g amino-TPO (Table 6) were added to 40 ml ethyl acetate. A solution of 3.3 g (24 mmol) potassium carbonate in 40 ml water was added upon which the acyl phosphine oxides completely dissolved. A solution of 1.76 g (10.4) diglycoloyl dichloride in 5 ml ethyl acetate was added over five minutes, while vigorously stirring. The temperature was maintained below 25°C. The reaction was allowed to continue for one hour at room temperature. TLC analysis proved full conversion (TLC Silicagel 60 $F_{254}$ supplied by MERCK, eluent : ethyl acetate, $R_f$ (amino-TPO) : 0.25, $R_f$ (amino-TPO L) : 0.43). The ethyl acetate phase was isolated, extracted with 40 ml of a 0.5 M NaCl solution in water, dried over $MgSO_4$ and evaporated under reduced pressure. The isolated INIMIX-2 to INIMIX-4 were analyzed using TLC analysis (TLC analysis on Uniplate™ Analtech HPTLC-RP18F plate supplied by MILES SCIENTIFIC : eluent MeOH/0.5 M NaCl 70/30, $R_f$ symmetrical TPO-L : 0.28, $R_f$ ASYM-5 : 0.20, $R_f$ symmetrical-TPO : 0.13). The structure of ASYM-5 was confirmed using TLC-MS.

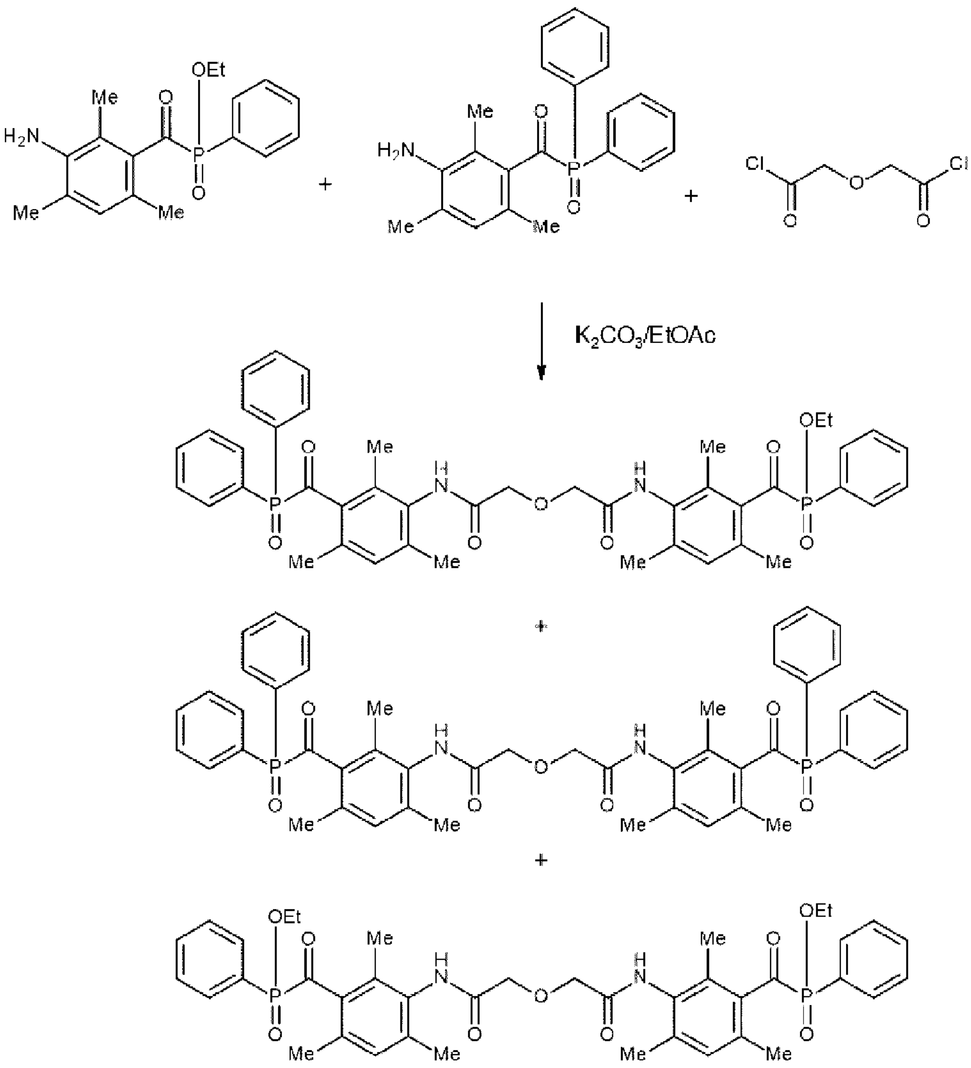


Synthesis of INIMIX-5 comprising ASYM-1

3.31 g (10 mmol) amino-TPO-L and 3.63 g (10 mmol) amino-TPO were dissolved in 46 g ethyl acetate. A solution of 3.04 g (12.5 mmol) potassium carbonate in 20 ml water was added and the reaction mixture was stirred. A solution of 2.67 g (11 mmol) diethyleneglycol bis(chloroformate) in 5 ml ethylacetate was added over 30 minutes upon which the temperature rose from 22 to 25°C. The reaction was allowed to continue for one hour. An additional 0.23 g (1 mmol) diethyleneglycol bis(chloroformate) was added and the reaction was allowed to continue for an additional hour. The organic fraction was isolated, washed with 40 ml of a 0.5 M sodium chloride solution and evaporated under reduced pressure. 8.7 g (y : 100 %) of INIMIX-5 was isolated (TLC analysis on a Uniplate™ Analtech HPTL-RP18F plate supplied by MILES SCIENTIFIC : eluent MeOH/0.5 M NaCl 70/30, $R_f$ symmetrical-TPO : 0.08, $R_f$ ASYM-1 : 0.11, $R_f$ symmetrical TPO-L : 0.28).

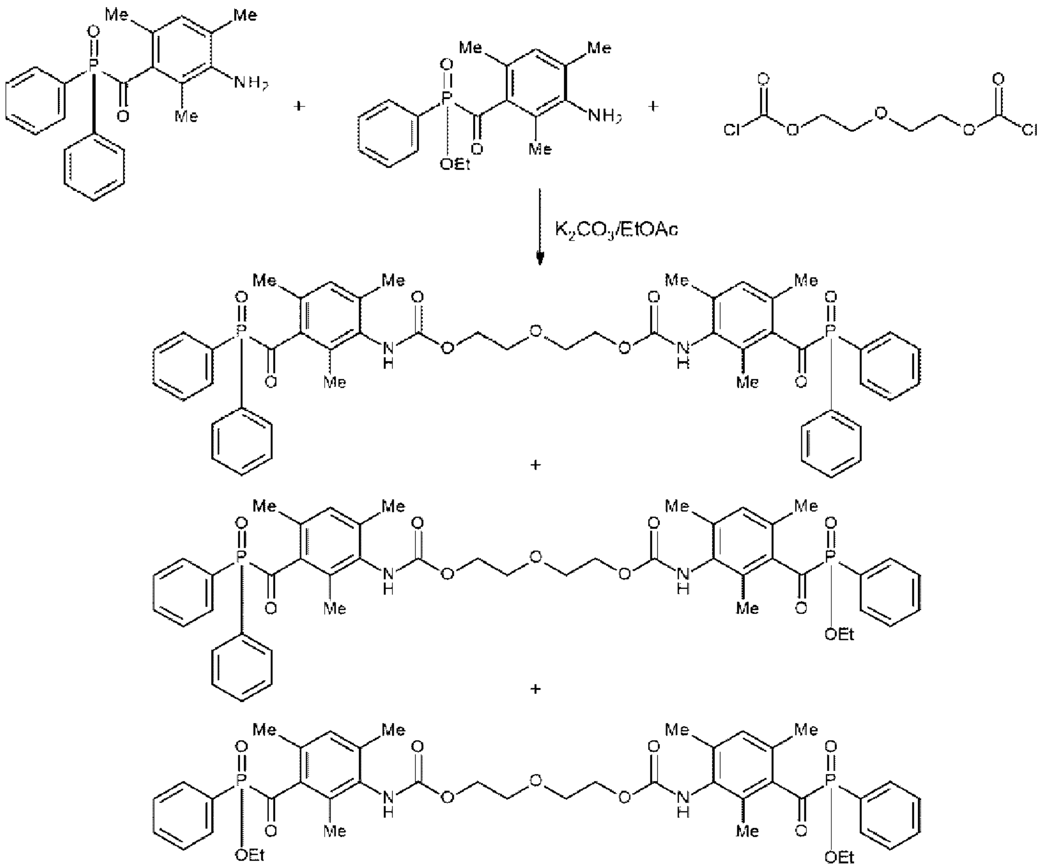


Synthesis of INIMIX-6 comprising ASYM-4

3.31 g (10 mmol) amino-TPO-L and 3.63 g (10 mmol) amino-TPO were dissolved in 46 g ethyl acetate. A solution of 3.04 g (12.5 mmol) potassium carbonate in 20 ml water was added and the reaction mixture was stirred. A solution of 2.2 g (11.5 mmol) adipoylchloride in 5 ml ethyl acetate was added over 10 minutes, while maintaining the temperature below 25°C. The reaction was allowed to continue for 16 hours at room temperature. The organic fraction was isolated, washed with 40 ml of a 0.5 M sodium chloride solution and evaporated under reduced pressure. 7.8 g (y : 97 %) INIMIX-6 was isolated (TLC analysis on a Uniplate™ Analtech HPTL-RP18F plate supplied by MILES SCIENTIFIC : eluent MeOH/0.5 M NaCl 70/30, $R_f$ symmetrical-TPO : 0.09, $R_f$ ASYM-4 : 0.15, $R_f$ symmetrical TPO-L : 0.23).

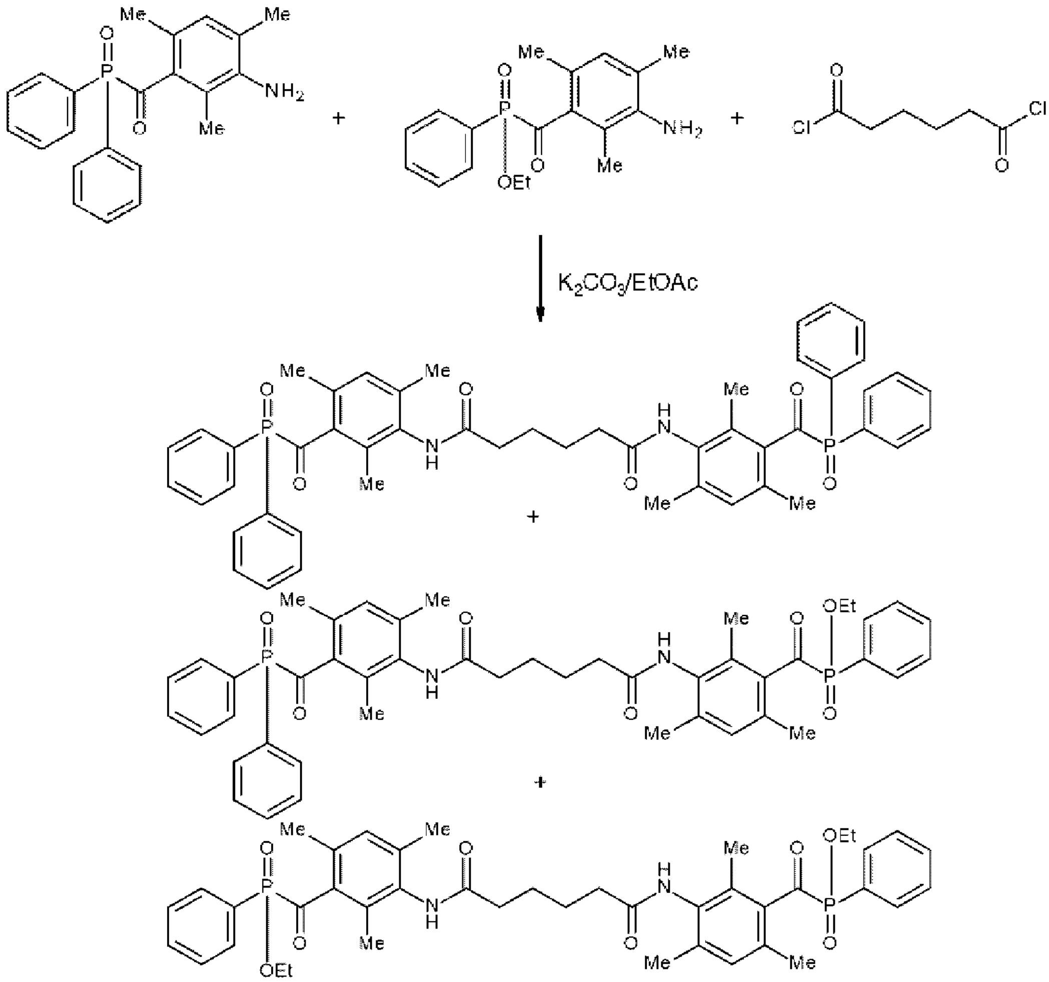


Synthesis of INIMIX-7 comprising ASYM-8

3.63 g (10 mmol) amino-TPO and 3.31 g (10 mmol) amino-TPO-L were dissolved in 30 ml acetonitrile. 2.21 g (10 mmol) 3,3,5-trimethylhexamethylene-1,6-diisocyante was added and the reaction mixture was heated to 63°C for 20 hours. The reaction mixture was allowed to cool down to room temperature and INIMIX-7 phase separated from the mixture. The INMIX-7 phase was washed with 30 ml acetonitrile, 40 ml ethyl acetate, 60 ml methyl tert.butyl ether and dried. The organic fractions, used for washing were pooled and evaporated under reduced pressure. Both fraction still contained a considerable amount of contaminants and were pooled. INIMIX-7 was purified by preparative column chromatography on a Büchi™ NP-Flash column, using a gradient elution from ethyl acetate to ethyl acetate/ methanol 75/25. 4.6 g (y : 50%) of INIMIX-7 was isolated (TLC analysis on a Uniplate™ Analtech HPTL-RP18F plate supplied by MILES SCIENTIFIC : eluent MeOH/0.5 M NaCl 80/20, $R_f$ symmetrical TPO : 0.12; $R_f$ ASYM-8 : 0.18; $R_f$ symmetrical TPO-L : 0.25).

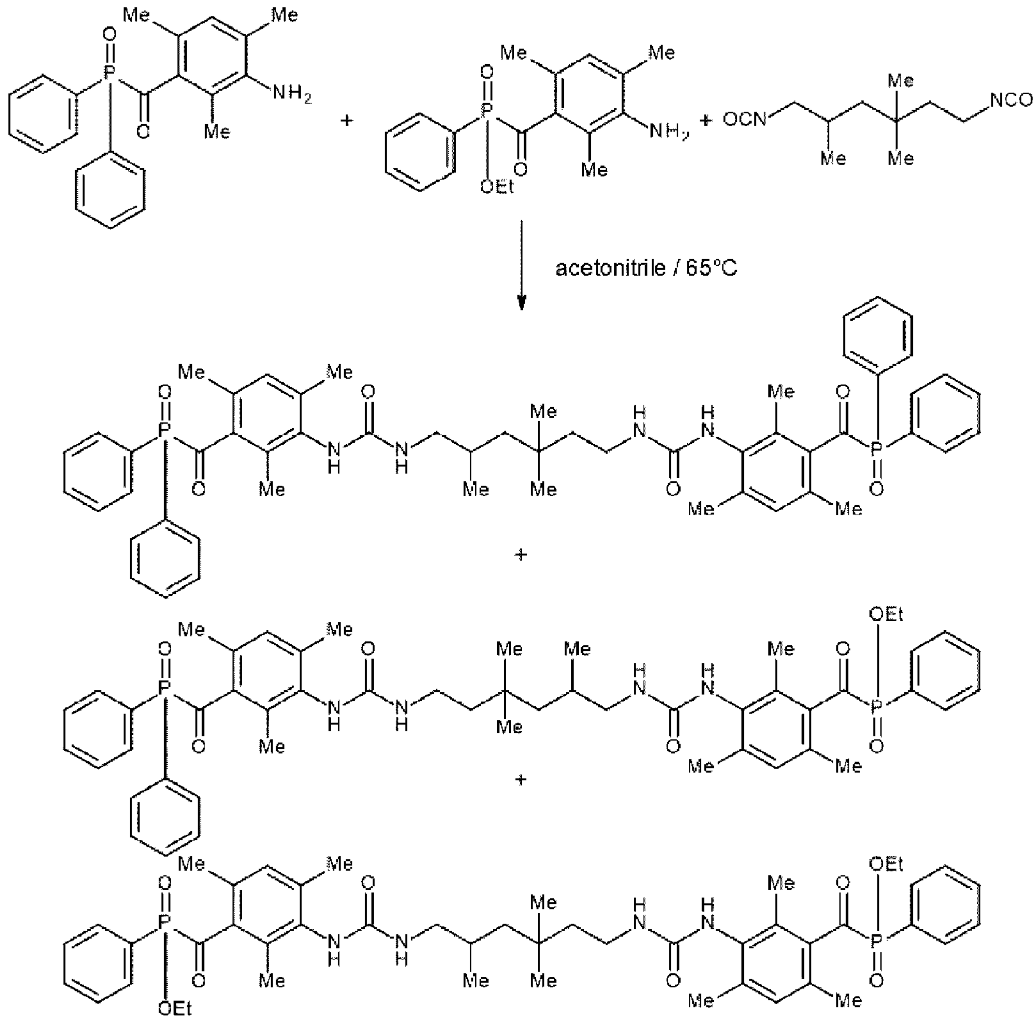


Synthesis of INIMIX-8 comprising ASYM-12

4.31 g (10 mmol) TPO-L-oxam and 4.63 g (10 mmol) TPO-oxam were added to 90 ml acetonitrile. A solution of 1.53 g (10 mmol) bis(3-aminopropyl)methyl amine in 5 ml acetonitrile was added and the mixture was heated to 80°C. The reaction was allowed to continue for 20 hours at 80°C. Upon cooling down to room temperature, a precipitate was formed. The precipitate was removed by filtration and the solvent was evaporated under reduced pressure. 8.4 g of the crude INIMIX-8 was isolated. INIMIX-8 was purified by preparative column chromatography on a Büchi™ NP-Flash column, using a gradient elution from ethyl acetate to ethyl acetate/ methanol 75/25. 3.5 g (y : 37 %) of INIMIX-8 was isolated (TLC analysis on a Uniplate™ Analtech HPTL-RP18F plate supplied by MILES SCIENTIFIC : eluent MeOH/1 M NaCl 80/20, $R_f$ symmetrical TPO : 0.26; $R_f$ ASYM-12 : 0.33; $R_f$ symmetrical TPO-L : 0.41).

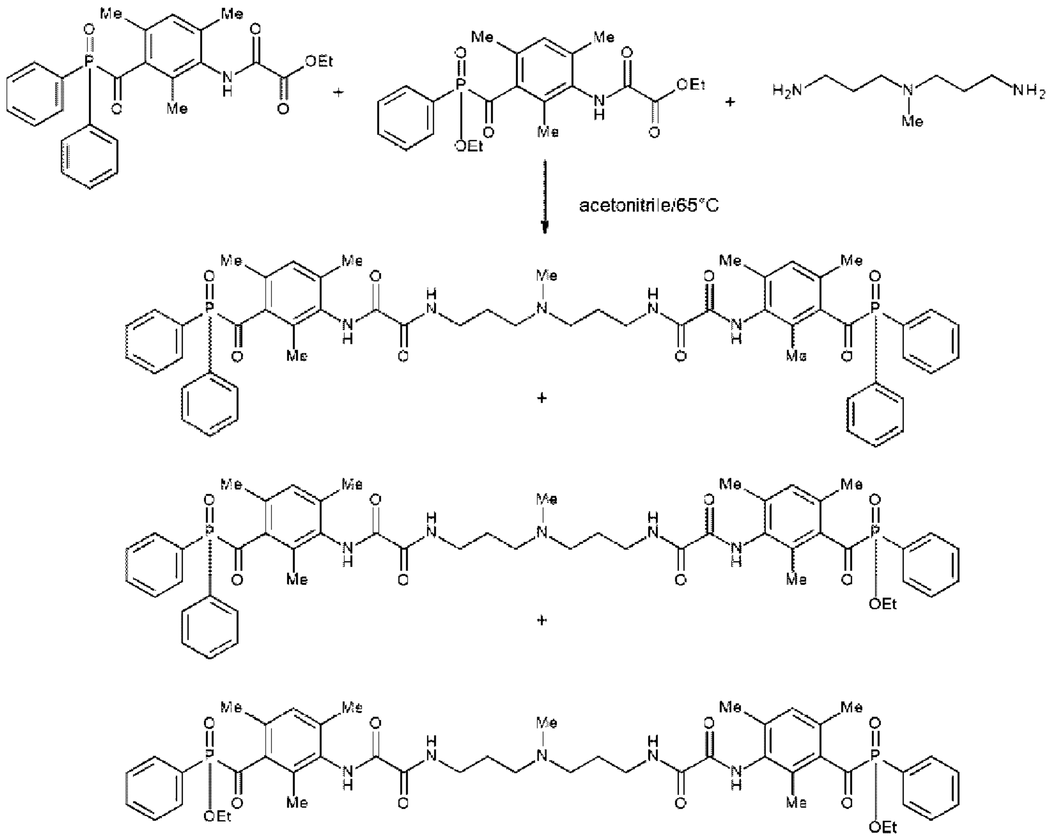


Synthesis of INIMIX-9 comprising ASYM-13

4.31 g (10 mmol) TPO-L-oxam and 4.63 g (10 mmol) TPO-oxam were added to 90 ml acetonitrile. A solution of 1.56 g (10 mmol) 3,6-dioxa-1,8-octane diamine in 5 ml acetonitrile was added and the mixture was heated to 75°C. The reaction was allowed to continue for 20 hours at 80°C. The reaction mixture was concentrated to 20 ml and the mixture was refluxed for an additional 20 hours. The solvent was removed under reduced pressure and INIMIX-9 was purified by preparative column chromatography on a Büchi™ NP-Flash column, using a gradient elution from ethyl acetate to ethyl acetate/ methanol 75/25. 2.6 g (y : 27%) of INIMIX-9 was isolated (TLC analysis on a Uniplate™ Analtech HPTL-RP18F plate supplied by MILES SCIENTIFIC : eluent MeOH/1 M NaCl 80/20, $R_f$ symmetrical TPO : 0.25; $R_f$ ASYM-13 : 0.31; $R_f$ symmetrical TPO-L : 0.39).

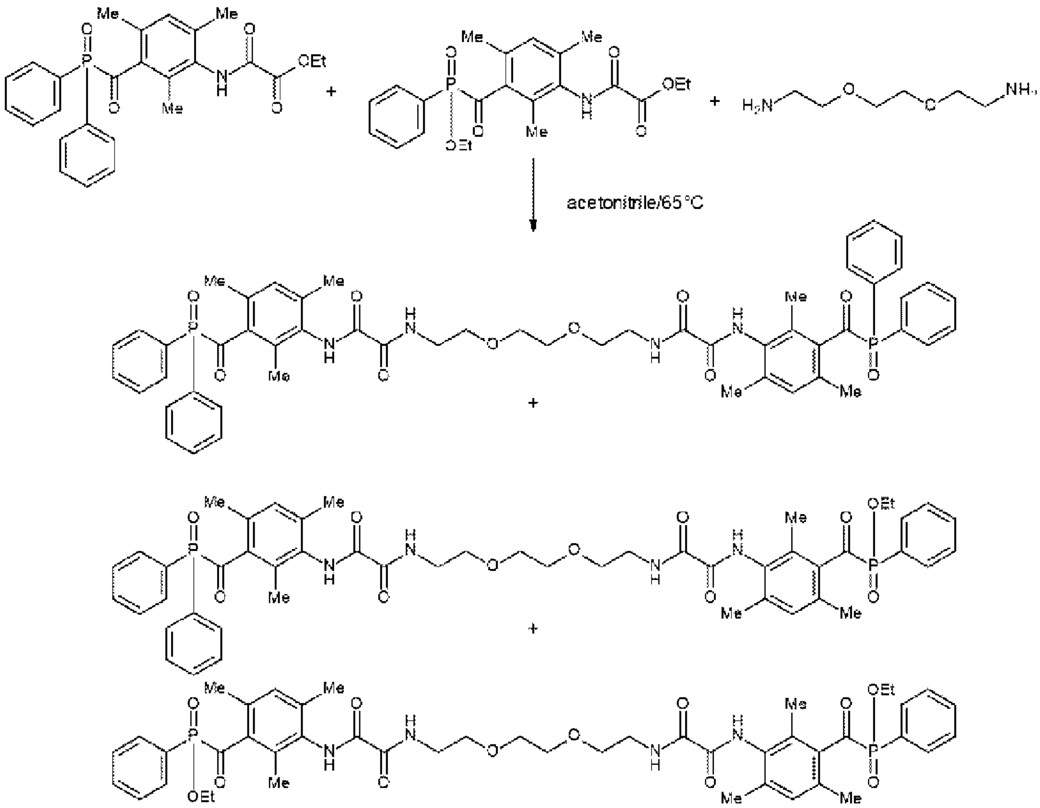


**Example 2**

This example illustrates that the photoinitiators according to the present invention have an optimal balance between formulation latitude and curing sensitivity with a curing sensitivity close to the common industrial acyl phosphine oxide initiators TPO and TPO-L.

Preparation of the LED curable compositions

The comparative examples C-1 to C-4 and the inventive examples I-1 to I-9 were prepared by mixing the components according to Table 7 and Table 8. The weight% (wt%) were based on the total weight of the LED curable compositions. The wt% of the photoinitiators is chosen such that the molar amount of acyl phosphine oxide moieties is the same in all photocurable compositions.

**Table 7**

| **wt% of** | **C-1** | **C-2** | **C-3** | **C-4** | **I-1** | **I-2** |
|---|---|---|---|---|---|---|
| **TPO** | 8.5 | - | - | - | - | - |
| **TPO-L** | - | 7.8 | - | - | - | - |
| **COMPINI-1** | - | - | 9.2 | - | - | - |
| **COMPINI-2** | - | - | - | 9.9 | - | - |
| **INIMIX-1** | - | - | - | - | 9.5 | - |
| **INIMIX-2** | - | - | - | - | - | 9.6 |
| **Genomer™ 2253** | 8.9 | 8.9 | 8.9 | 8.9 | 8.9 | 8.9 |
| **Sliwet™ L7500** | 1.0 | 1.0 | 1.0 | 1.0 | 1.0 | 1.0 |
| **VEEA** | 81.6 | 82.3 | 80.9 | 80.2 | 80.6 | 80.5 |

**Table 8**

| wt% of | I-3 | I-4 | I-5 | I-6 | I-7 | I-8 | I-9 |
|---|---|---|---|---|---|---|---|
| **INIMIX-3** | 9.7 | - | - | - | - | - | - |
| **INIMIX-4** | - | 9.4 | - | - | - | - | - |
| **INIMIX-5** | - | - | 10.4 | - | - | - | - |
| **INIMIX-6** | - | - | - | 9.8 | - | - | - |
| **INIMIX-7** | - | - | - | - | 10.6 | - | - |
| **INIMIX-8** | - | - | - | - | - | 11.6 | - |
| **INIMIX-9** | - | - | - | - | - | - | 11.6 |
| **Genomer™ 2253** | 8.9 | 8.9 | 8.9 | 8.9 | 8.9 | 8.9 | 8.9 |
| **Silwet™ L7500** | 1.0 | 1.0 | 1.0 | 1.0 | 1.0 | 1.0 | 1.0 |
| **VEEA** | 80.4 | 80.7 | 79.7 | 80.3 | 79.5 | 78.5 | 78.5 |

Results and Evaluation

The curability and the smell of the photocurable compositions C-1 to C-4 and I-1 to I-9 were determined. The results are shown in Table 9.

**Table 9**

| Cured product | Photoinitiator | Number of passes | Surface cure | Smell of cured product |
|---|---|---|---|---|
| **C-1** | TPO | 1 | 0 | Reference |
| **C-2** | TPO-L | 3 | 0 | Not improved |
| **C-3** | COMPINI-1 | 10 | 5 | I m proved |
| **C-4** | COMPINI-2 | 10 | 5 | I m proved |
| **I-1** | ASYM-2 | 2 | 0 | I m proved |
| **I-2** | ASYM-5 | 1 | 0 | I m proved |
| **I-3** | ASYM-5 | 1 | 0 | I m proved |
| **I-4** | ASYM-5 | 1 | 0 | I m proved |
| **I-5** | ASYM-1 | 1 | 0 | I m proved |
| **I-6** | ASYM-4 | 2 | 0 | I m proved |
| **I-7** | ASYM-8 | 3 | 0 | I m proved |
| **I-8** | ASYM-12 | 1 | 0 | I m proved |
| **I-9** | ASYM-13 | 1 | 0 | I m proved |

By comparing the cured products C-1 to C-4 and I-1, it can be seen that only the photocurable composition I-1 exhibited good curability and an improved smell of the cured product. The photocurable compositions C-1 and C-2 containing the commonly used TPO respectively TPO-L exhibited also good curability, but the cured product had a bad smell. The photoinitiators COMPINI-1 and COMPINI-2 can be called "symmetrical" acyl phosphine oxides as they both contain two identical acyl phosphine oxide moieties, more particularly two TPO-L moieties respectively TPO moieties. The photoinitiator ASYM-2 of the photocurable composition I-1 can be called an "asymmetrical" acyl phosphine oxide as it contains one TPO-L moiety and one TPO moiety. Surprisingly only the asymmetrical acyl phosphine oxide ASYM-2 provides good curability although the linking group of COMPINI-1, COMPINI-2 and ASYM-2 is identical.

The curability can be further improved by including an ether function in the linking group as shown by photoinitiator ASYM-5 in the photocurable compositions I-2 to I-4 compared to ASYM-2 in the photocurable composition I-1. The amount of photoinitiator ASYM-5 in the photocurable compositions I-2 to I-4 does not appear to affect the curability as long as it is present.

The improvement on curability by including one or more ether groups in the linking group is confirmed by the

photocurable compositions I-5 and I-9 compared to the photocurable compositions I-6 and I-7 where the linking group lacks an ether function.

The photocurable composition I-8 illustrates that the inclusion of a tertiary amine group in the linking group also improves the curability.

No photo-yellowing problems were observed for the photocurable compositions C-1 to C-4 and I-1 to I-9.

**Example 3**

This example illustrates that the advantages of the photoinitiators according to the present invention are also obtained for different monomer in the photocurable composition.

Preparation of the LED curable compositions

The comparative examples C-5 and C-6 and the inventive example I-10 were prepared by mixing the components according to Table 10. The weight% (wt%) were based on the total weight of the LED curable compositions. The wt% of the photoinitiators is chosen such that the molar amount of acyl phosphine oxide moieties is the same in all photocurable compositions.

**Table 10**

| wt% of | C-5 | C-6 | I-10 |
|---|---|---|---|
| COMPINI-3 | 10.2 | - | - |
| COMPINI-4 | - | 9.4 | - |
| INIMIX-6 | - | - | 9.8 |
| DPGDA | 79.9 | 80.7 | 80.3 |
| Genomer™ 2253 | 8.9 | 8.9 | 8.9 |
| Silwet™ L7500 | 1.0 | 1.0 | 1.0 |

Results an Evaluation

The curability of the photocurable compositions C-5, C-6 and I-10 were determined. The results are shown in Table 11.

**Table 11**

| Cured product | Number of passes |
|---|---|
| **C-5** | >10 |
| **C-6** | 10 |
| **I-10** | 1 |

It should me immediately clear from Table 11 that the asymmetrical acyl phosphine oxide in the photocurable composition I-10 provides excellent curability compared the photocurable compositions C-5 and C-6 containing analogous symmetrical acyl phosphine oxides.

**Example 4**

This example illustrates the inkjet printing of a photocurable inkjet ink including a photoinitiator according to the invention.

Preparation of the concentrated cyan dispersion DISP-C

A concentrated cyan pigment dispersion was prepared by mixing for 30 minutes the components according to Table 12 using a DISPERLUX™ disperser from DISPERLUX S.A.R.L., Luxembourg. The vessel was then connected to a Bachofen DYNOMILL™ ECM Poly mill having an internal volume of 8.2 L filled for 42% with 0.4 mm yttrium stabilized

zirconia beads. The mixture was circulated over the mill at a flow rate of about 8 L per minute to have a residence time of 38 min. After milling the dispersion was separated from the beads using a 1 μm filter. The average particle size of the pigment particles in the concentrated cyan pigment dispersion DISP-C was found to be 89 nm.

**Table 12**

| component | wt% |
|---|---|
| PB15:4 | 25 |
| DB162 | 10 |
| INHIB | 1 |
| DPGDA | 64 |

Preparation of the cyan ink jet inks

The comparative ink jet ink COMP-1 and the inventive ink jet inks INV-1 to INV-3 were prepared using the concentrated cyan pigment dispersion DISP-C and mixing it with the components as shown in Table 13. The weight percentages (wt%) are based on the total weight of the ink jet ink.

**Table 13**

| wt% of | COMP-1 | INV-1 | INV-2 | INV-3 |
|---|---|---|---|---|
| TPO-L | 10 | - | - | - |
| INIMIX-4 | - | 10 | - | - |
| INIMIX-5 | - | - | 10 | - |
| INIMIX-6 | - | - | - | 10 |
| DISP-C | 15 | 15 | 15 | 15 |
| Genomer™ 2253 | 9 | 9 | 9 | 9 |
| VEEA | 65 | 65 | 65 | 65 |
| Silwet™ L7500 | 1 | 1 | 1 | 1 |

Evaluation of the cyan ink jet inks

The comparative ink COMP-1 and the inventive inks INV-1 to INV-3 were jetted on a Synaps™ OM135/AP from AGFA using a Dimatix™ 10 pl printhead. A jetting frequency of 5KHz was used in combination with a jetting voltage of 31 V. The jetting temperature was adjusted for each inkjet ink until all nozzles jetted and is given below in Table 14.

**Table 14**

| Ink jet Ink | Jetting temperature (°C) |
|---|---|
| COMP-1 | 35 |
| INV-1 | 42 |
| INV-2 | 42 |
| INV-3 | 41 |

The printed samples were cured using a Fusion DRSE-120 conveyer, equipped with a UV LED module Unijet™ i24511 from USHIO, which transported the samples under the UV-lamp on a conveyer belt at a speed of 20 m/min. The full power of the UV LED was used. The curing degree was evaluated after one pass by wiping 10 times with a Q-tip and evaluating the surface damage. The surface damage was scored according to Table 15:

**Table 15**

| Score Surface cure | Observation |
|---|---|
| **0** | no visual damage |
| **1** | a change in surface gloss without leaving a trace of ink on the Q-tip |
| **2** | clear surface damage with clear ink contamination on the Q-tip |
| **3** | the full ink layer damaged |
| **4** | almost full removal of the ink layer |
| **5** | ink layer was completely removed upon wiping |

The surface damage evaluation of the comparative ink COMP-1 and the inventive inks INV-1 to INV-3 is summarized in Table 16.

**Table 16**

| Ink jet ink | Surface damage |
|---|---|
| **COMP-1** | 1 |
| **INV-1** | 1 |
| **INV-2** | 1 |
| **INV-3** | 1 |

From this evaluation, it becomes clear that the inks comprising an acyl phosphine oxide photoinitiator according to the present invention are readily jettable using standard piezo printheads, without loss in curing sensitivity compared to a standard acyl phosphine oxide photoinitiator. Also no photo-yellowing problems were observed.

## Claims

**1.** A photoinitiator including 2 to 6 monoacyl phosphine oxide moieties **characterized in that** the monoacyl phosphine oxide moieties are linked to each other via their acyl group and that at least 2 monoacyl phosphine oxide moieties have a chemical structure differing in the phosphine oxide part.

**2.** The photoinitiator as claimed in claim 1, wherein the photoinitiator includes 2 or 3 monoacyl phosphine oxide moieties.

**3.** The photoinitiator as claimed in claim 1 or 2, wherein the linking group between the monoacyl phosphine oxide moieties includes a free radical polymerizable group.

**4.** The photoinitiator as claimed in claim 1 or 2 having a structure according to Formula (1):

$$[A]_y - L - [B]_x \qquad \text{Formula (1),}$$

wherein

x and y independently represent an integer from 1 to 3;
L represents an (x+y)-valent linking group having no more than 25 carbon atoms;
A represents a acyl phosphine oxide according to Formula (1-1):

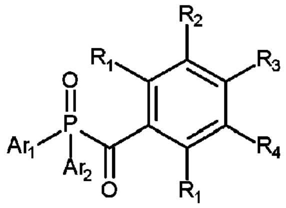

Formula (1-1),

wherein
$Ar_1$ and $Ar_2$ independently represent a substituted or unsubstituted aryl or heteroaryl group;
$R_1$ is selected from the group consisting of a substituted or unsubstituted alkyl group, a substituted or unsubstituted aryl group and a substituted or unsubstituted alkoxy-group; and
$R_2$, $R_3$ and $R_4$ are independently selected from the group consisting of the coupling position to L or a substituent selected from the group consisting of a hydrogen, a substituted or unsubstituted alkyl group, a substituted or unsubstituted alkenyl group, a substituted or unsubstituted alkynyl group, a substituted or unsubstituted alkoxy group and a substituted or unsubstituted aryl or heteroaryl group;
B represents a acyl phosphine oxide moiety according to Formula (1-2):

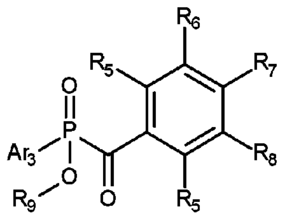

Formula (1-2),

wherein $Ar_3$ represent a substituted or unsubstituted aryl or heteroaryl group; $R_5$ is selected from the group consisting of a substituted or unsubstituted alkyl group, a substituted or unsubstituted aryl group and a substituted or unsubstituted alkoxy-group;
$R_6$, $R_7$ and $R_8$ are independently selected from the group consisting of the coupling position to L or a substituent selected from the group consisting of a hydrogen, a substituted or unsubstituted alkyl group, a substituted or unsubstituted alkenyl group, a substituted or unsubstituted alkynyl group, a substituted or unsubstituted alkoxy group and a substituted or unsubstituted aryl or heteroaryl group; and
$R_9$ represents a substituted or unsubstituted alkyl group, a substituted or unsubstituted alkenyl group, a substituted or unsubstituted alkynyl group and a substituted or unsubstituted aryl or heteroaryl group.

**5.** The photoinitiator as claimed in claim 4, wherein the ratio of molecular weight between A and B on the one hand and L on the other hand meets the following equation: $(x * Mw(A) + y * Mw(B))/ Mw(L) \geq 1.5$.

**6.** The photoinitiator as claimed in claim 1 or 2 having a structure according to Formula (2):

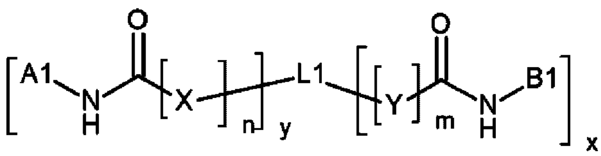

Formula (2),

wherein

n and m independently represent 0 or 1;
x and y independently represent an integer from 1 to 3;
L1 represents an (x+y)-valent linking group having no more than 25 carbon atoms;
X and Y independently represent O or NH;
A1 represents an acyl phosphine oxide moiety according to Formula (2-1):

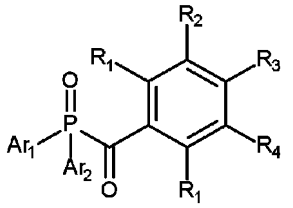

Formula (2-1),

wherein $Ar_1$ and $Ar_2$ independently represent a substituted or unsubstituted aryl or heteroaryl group; $R_1$ is selected from the group consisting of a substituted or unsubstituted alkyl group, a substituted or unsubstituted aryl group and a substituted or unsubstituted alkoxy-group; $R_2$, $R_3$ and $R_4$ are independently selected from the group consisting of the coupling position to N or a substituent selected from the group consisting of a hydrogen, a substituted or unsubstituted alkyl group, a substituted or unsubstituted alkenyl group, a substituted or unsubstituted alkynyl group, a substituted or unsubstituted alkoxy group and a substituted or unsubstituted aryl or heteroaryl group;

B1 represents an acyl phosphine oxide moiety according to Formula (2-2):

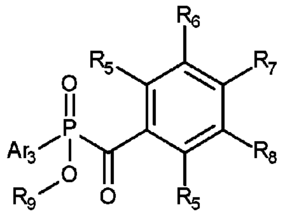

Formula (2-2),

wherein $Ar_3$ represent a substituted or unsubstituted aryl or heteroaryl group; $R_5$ is selected from the group consisting of a substituted or unsubstituted alkyl group, a substituted or unsubstituted aryl group and a substituted or unsubstituted alkoxy-group; $R_6$, $R_7$ and $R_8$ are independently selected from the group consisting of the coupling position to N or a substituent selected from the group consisting of a hydrogen, a substituted or unsubstituted alkyl group, a substituted or unsubstituted alkenyl group, a substituted or unsubstituted alkynyl group, a substituted or unsubstituted alkoxy group and a substituted or unsubstituted aryl or heteroaryl group; $R_9$ represents a substituted or unsubstituted alkyl group, a substituted or unsubstituted alkenyl group, a substituted or unsubstituted alkynyl group and a substituted or unsubstituted aryl or heteroaryl group.

7. The photoinitiator as claimed in any one of claims 4 to 6, wherein the linking group L or L1 comprises at least one ether function or a tertiary amine group.

8. The photoinitiator as claimed in claim 1, wherein the photoinitiator is selected from the group consisting of:

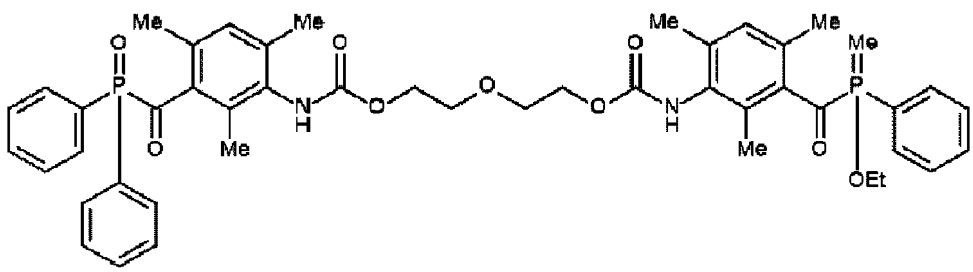

,

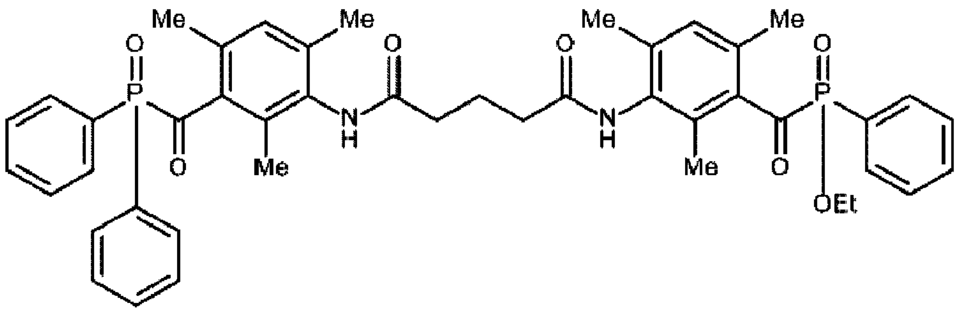

,

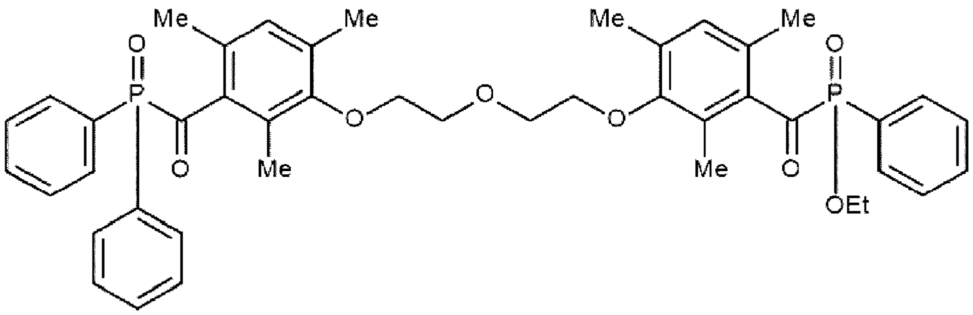

,

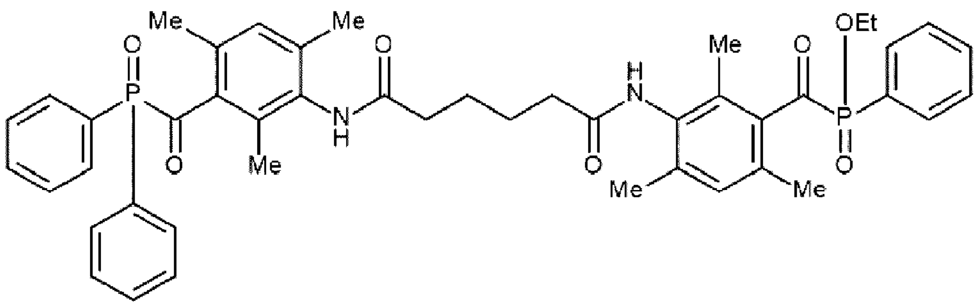

,

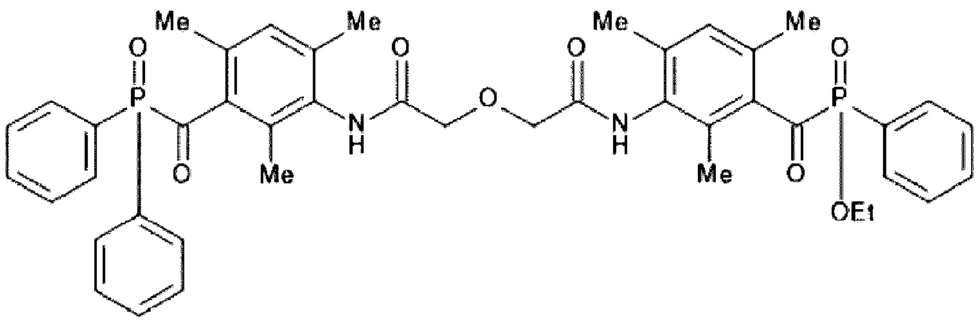

,

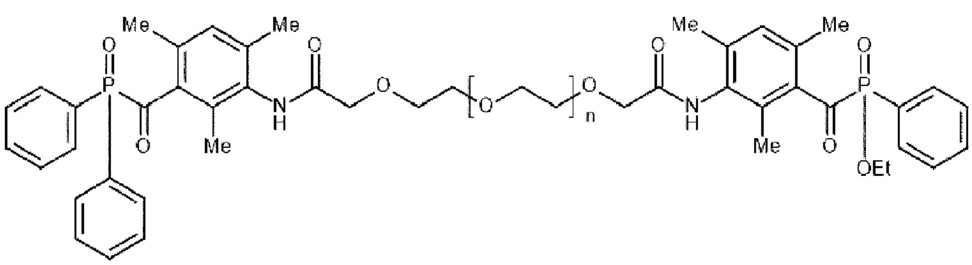

n=2 on average,

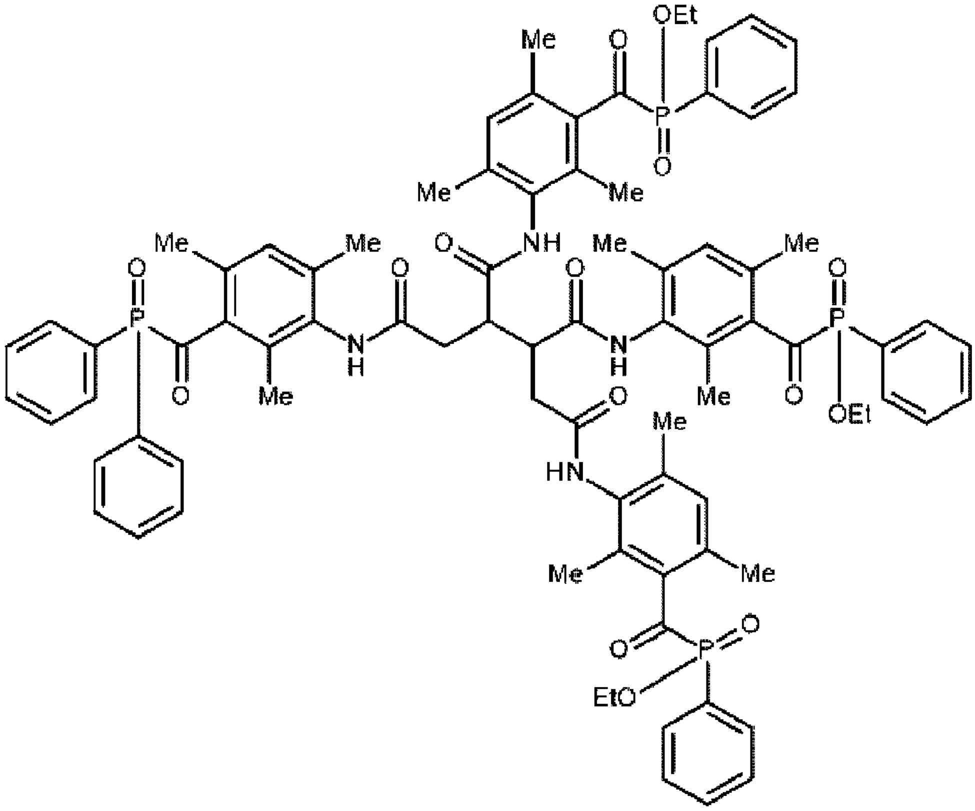

,

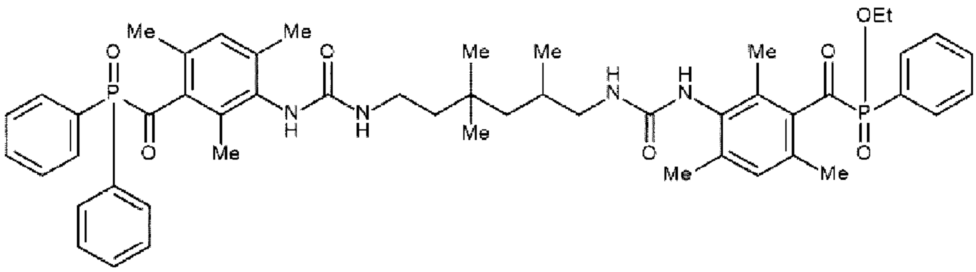

,

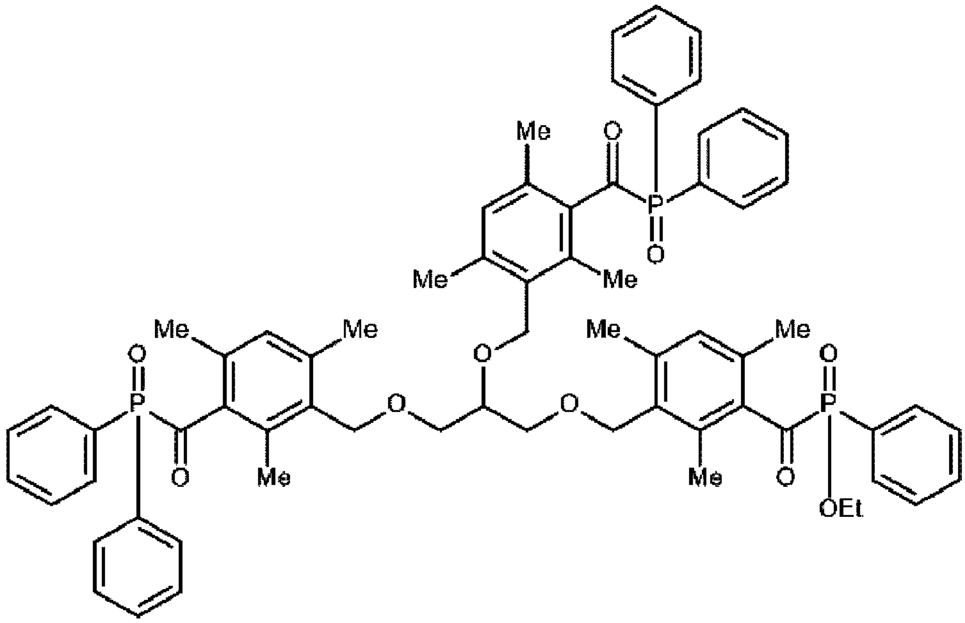

,

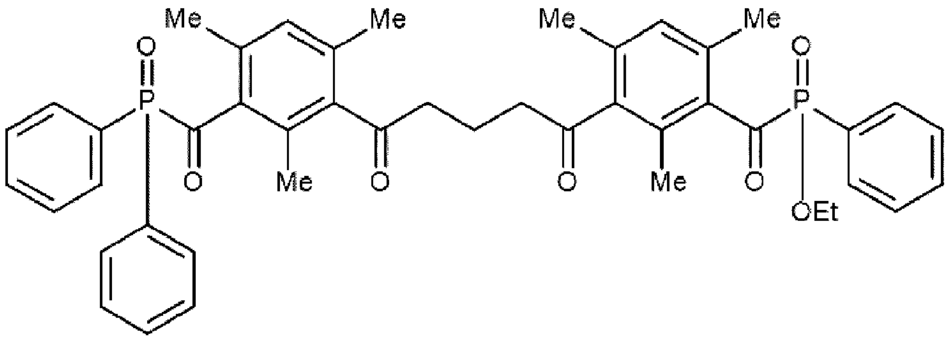

,

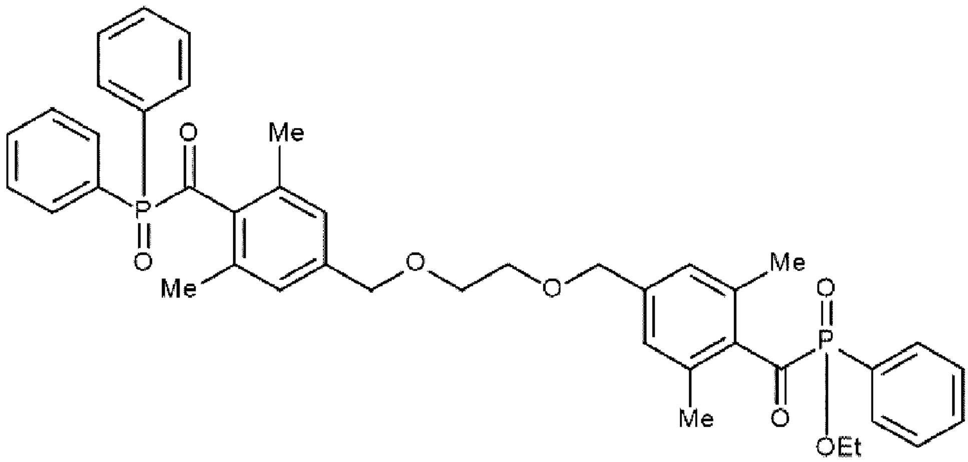

,

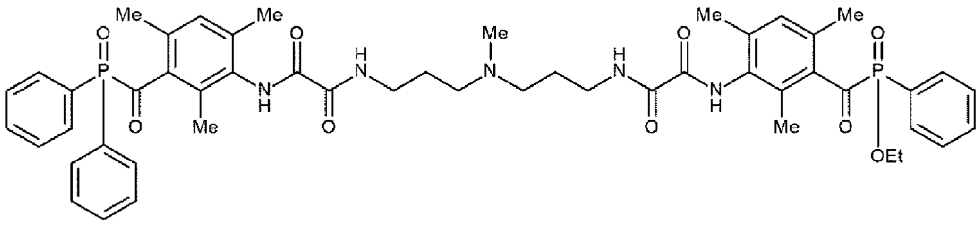

,

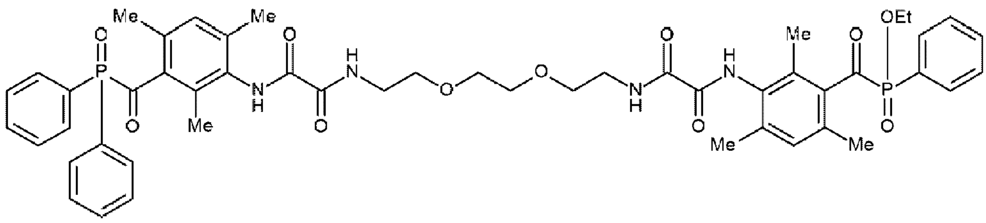

,

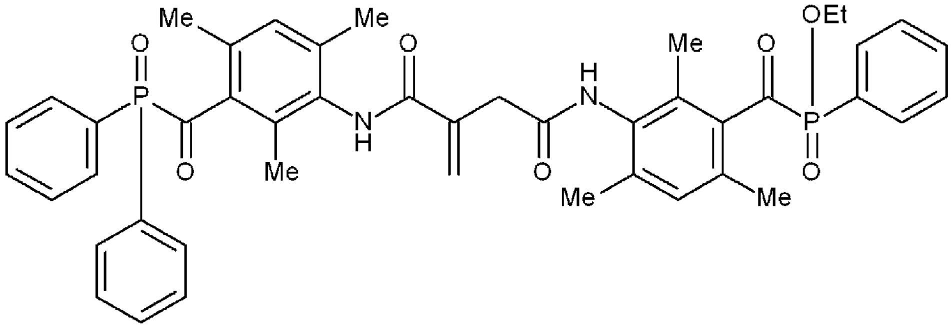

,

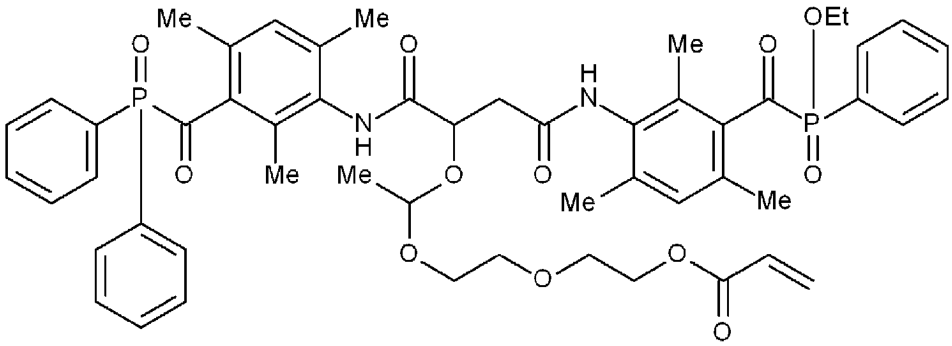

,

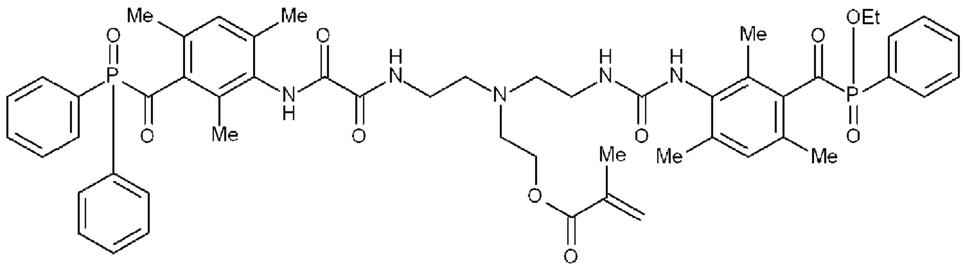

,

and

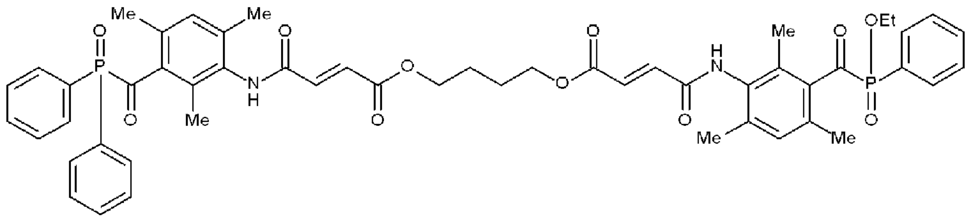

9. A mixture of photo initiators including at least one photoinitiator according to claim 4 or 6, wherein the photoinitiator according to Formula (1) with x and y representing the integer 1 is part of the mixture comprising the photoinitiators according to Formula (1-a), Formula (1-b), and Formula (1-c) with the groups A, B and L as defined as for the photoinitiator according to Formula (1), wherein Formula (1-a) is A-L-B, Formula (1-b) is A-L-A, and Formula (1-c) is B-L-B; and wherein the mixture comprises between 20 and 80 mol% of the photoinitiator according to Formula (1-a);

or wherein the photoinitiator according to Formula (2) with x and y representing the integer 1 is part of a mixture of photoinitiators comprising the photoinitiators according to Formula (2a), Formula (2-b), and Formula (2-c) with the groups A' being A-NH-C(=O)-$(X)_n$-, B' being B-NH-C(=O)-$(Y)_m$-, and L1 as defined as for the photoinitiator according to Formula (2), wherein
Formula (2-a) is A'-L1-B', Formula (2-b) is A'-L1-A', and Formula (2-c) is B'-L1-B'; and wherein the mixture comprises between 20 and 80 mol% of the photoinitiator according to Formula (2-a).

10. A photocurable composition comprising a photoinitiator of any one of claims 1 to 8 and a free radical polymerizable compound as essential components.

11. The photocurable composition according to claim 10 comprising a mixture of photo initiators according to either claim 9.

12. A photocurable ink comprising a pigment and the photocurable composition of claim 10 or 11.

13. A cured product, wherein the cured product is formed by UV LED curing the photocurable composition of any one of claims 10 to 12.

14. A manufacturing method of a photoinitiator mixture including a photoinitiator according to any one of claims 1 to 8 including the steps of:

a) mixing 2 monoacyl phosphine oxide compounds having a chemical structure differing in the phosphine oxide part and each having attached to the acyl part a primary amine group or a group according to Formula (M-1) in a molar ratio of 3:1 to 1:3; and
b) reacting the 2 monoacyl phosphine oxide compounds with a compound linking the 2 monoacyl phosphine oxide compounds via the primary amine group or the group according to Formula (M-1);
wherein the group according to Formula (M-1) is:

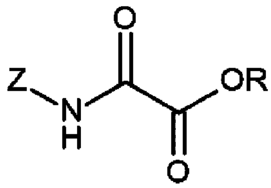
Formula (M-1),

wherein Z represents a carbon atom of an aromatic ring in the acyl part, and R represents a $C_1$ to $C_6$-alkyl group, preferably an ethyl group.

15. Use of a photoinitiator according to any one of claims 1 to 8 for improving the surface curing of a photocurable composition and/or reducing the smell of a cured product of a photocurable composition.

## Patentansprüche

1. Ein Fotoinitiator, der 2 bis 6 Monoacylphosphinoxidreste enthält, **dadurch gekennzeichnet, dass** die Monoacylphosphinoxidreste über ihre Acylgruppe miteinander verbunden sind und mindestens 2 Monoacylphosphinoxidreste eine unterschiedliche chemische Struktur im Phosphinoxidteil aufweisen.

2. Der Fotoinitiator nach Anspruch 1, wobei der Fotoinitiator 2 oder 3 Monoacylphosphinoxidreste enthält.

3. Der Fotoinitiator nach Anspruch 1 oder 2, wobei die Verbindungsgruppe zwischen den Monoacylphosphinoxidresten eine durch freie Radikale polymerisierbare Gruppe umfasst.

4. Der Fotoinitiator nach Anspruch 1 oder 2, der eine Struktur gemäß Formel (1) hat:

$$[A]_y - L - [B]_x \qquad \text{Formel (1),}$$

in der

x und y unabhängig voneinander eine ganze Zahl von 1 bis 3 bedeuten,
L eine (x+y)-valente Verbindungsgruppe mit nicht mehr als 25 Kohlenstoffatomen bedeutet,
A ein Acylphosphinoxid gemäß Formel (1-1) bedeutet:

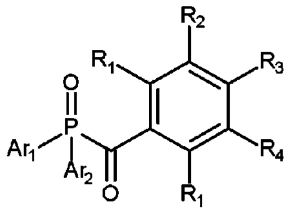

Formel (1-1),

in der
$Ar_1$ und $Ar_2$ unabhängig voneinander eine substituierte oder nicht-substituierte Arylgruppe oder Heteroarylgruppe bedeuten,
$R_1$ aus der Gruppe bestehend aus einer substituierten oder nicht-substituierten Alkylgruppe, einer substituierten oder nicht-substituierten Arylgruppe und einer substituierten oder nicht-substituierten Alkoxygruppe ausgewählt wird, und
$R_2$, $R_3$ und $R_4$ unabhängig voneinander aus der Gruppe bestehend aus der Bindungsstelle an L oder einem Substituenten, ausgewählt aus der Gruppe bestehend aus Wasserstoff, einer substituierten oder nicht-substituierten Alkylgruppe, einer substituierten oder nicht-substituierten Alkenylgruppe, einer substituierten oder nicht-substituierten Alkynylgruppe, einer substituierten oder nicht-substituierten Alkoxygruppe und einer substituierten oder nicht-substituierten Arylgruppe oder Heteroarylgruppe, ausgewählt werden,
B einen Acylphosphinoxidrest gemäß Formel (1-2) bedeutet:

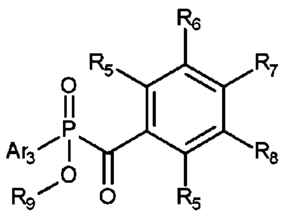

Formel (1-2),

in der
$Ar_3$ eine substituierte oder nicht-substituierte Arylgruppe oder Heteroarylgruppe bedeutet,
$R_5$ aus der Gruppe bestehend aus einer substituierten oder nicht-substituierten Alkylgruppe, einer substituierten oder nicht-substituierten Arylgruppe und einer substituierten oder nicht-substituierten Alkoxygruppe ausgewählt wird,
$R_6$, $R_7$ und $R_8$ unabhängig voneinander aus der Gruppe bestehend aus der Bindungsstelle an L oder einem Substituenten, ausgewählt aus der Gruppe bestehend aus Wasserstoff, einer substituierten oder nicht-substituierten oder nicht-sub-

stituierten Alkylgruppe, einer substituierten oder nicht-substituierten Alkenylgruppe, einer substituierten oder nicht-substituierten Alkynylgruppe, einer substituierten oder nicht-substituierten Alkoxygruppe und einer substituierten oder nicht-substituierten Arylgruppe oder Heteroarylgruppe, ausgewählt werden, und
$R_9$ eine substituierte oder nicht-substituierte Alkylgruppe, eine substituierte oder nicht-substituierte Alkenylgruppe, eine substituierte oder nicht-substituierte Alkynylgruppe und eine substituierte oder nicht-substituierte Arylgruppe oder Heteroarylgruppe bedeutet.

**5.** Der Fotoinitiator nach Anspruch 4, wobei das Molekulargewichtsverhältnis zwischen einerseits A und B und anderseits L folgende Gleichung erfüllt: $(x * Mw(A) + y * Mw(B))/ Mw(L) \geq 1{,}5$.

**6.** Der Fotoinitiator nach Anspruch 1 oder 2, der eine Struktur gemäß Formel (2) hat:

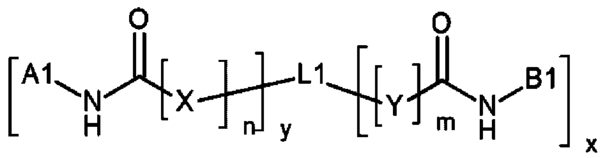

Formel (2),

in der

n und m unabhängig voneinander 0 oder 1 bedeuten,
x und y unabhängig voneinander eine ganze Zahl von 1 bis 3 bedeuten,
L1 eine (x+y)-valente Verbindungsgruppe mit nicht mehr als 25 Kohlenstoffatomen bedeutet,
X und Y unabhängig voneinander O oder NH bedeuten,
A1 einen Acylphosphinoxidrest gemäß Formel (2-1) bedeutet:

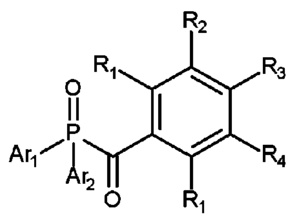

Formel (2-1),

in der
$Ar_1$ und $Ar_2$ unabhängig voneinander eine substituierte oder nicht-substituierte Arylgruppe oder Heteroarylgruppe bedeuten, $R_1$ aus der Gruppe bestehend aus einer substituierten oder nicht-substituierten Alkylgruppe, einer substituierten oder nicht-substituierten Arylgruppe und einer substituierten oder nicht-substituierten Alkoxygruppe ausgewählt wird, $R_2$, $R_3$ und $R_4$ unabhängig voneinander aus der Gruppe bestehend aus der Bindungsstelle an N oder einem Substituenten, ausgewählt aus der Gruppe bestehend aus Wasserstoff, einer substituierten oder nicht-substituierten Alkylgruppe, einer substituierten oder nicht-substituierten Alkenylgruppe, einer substituierten oder nicht-substituierten Alkynylgruppe, einer substituierten oder nicht-substituierten Alkoxygruppe und einer substituierten oder nicht-substituierten Arylgruppe oder Heteroarylgruppe, ausgewählt werden,
B1 einen Acylphosphinoxidrest gemäß Formel (2-2) bedeutet:

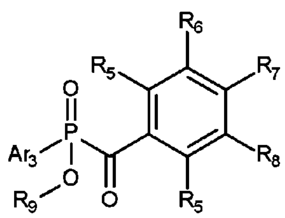

Formel (2-2),

in der $Ar_3$ eine substituierte oder nicht-substituierte Arylgruppe oder Heteroarylgruppe bedeutet, $R_5$ aus der Gruppe bestehend aus einer substituierten oder nicht-substituierten Alkylgruppe, einer substituierten oder nicht-substituierten Arylgruppe und einer substituierten oder nicht-substituierten Alkoxygruppe ausgewählt wird, $R_6$, $R_7$ und $R_8$ unabhängig voneinander aus der Gruppe bestehend aus der Bindungsstelle an N oder einem Substituenten, ausgewählt aus der Gruppe bestehend aus Wasserstoff, einer substituierten oder nicht-substituierten Alkylgruppe, einer substituierten oder nicht-substituierten Alkenylgruppe, einer substituierten oder nicht-substituierten Alkynylgruppe, einer substituierten oder nicht-substituierten Alkoxygruppe und einer substituierten oder nicht-substituierten Arylgruppe oder Heteroarylgruppe, ausgewählt werden, $R_9$ eine substituierte oder nicht-substituierte Alkylgruppe, eine substituierte oder nicht-substituierte Alkenylgruppe, eine substituierte oder nicht-substituierte Alkynylgruppe und eine substituierte oder nicht-substituierte Arylgruppe oder Heteroarylgruppe bedeutet.

**7.** Der Fotoinitiator nach einem der Ansprüche 4 bis 6, wobei die Verbindungsgruppe L oder L1 mindestens eine Etherfunktion oder eine tertiäre Aminogruppe umfasst.

**8.** Der Fotoinitiator nach Anspruch 1, wobei der Fotoinitiator ausgewählt wird aus der Gruppe bestehend aus:

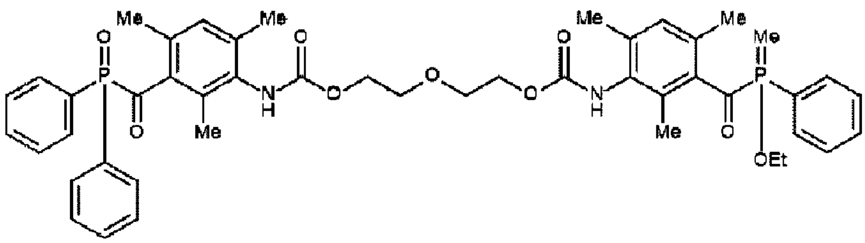

,

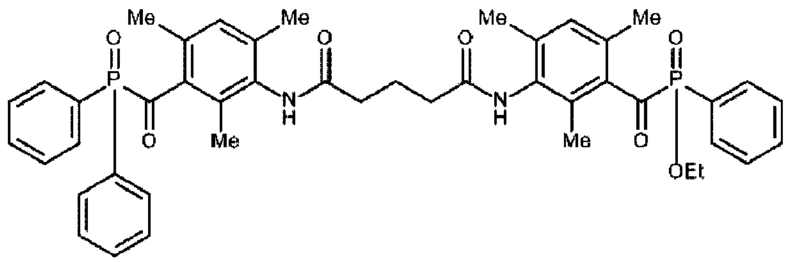

,

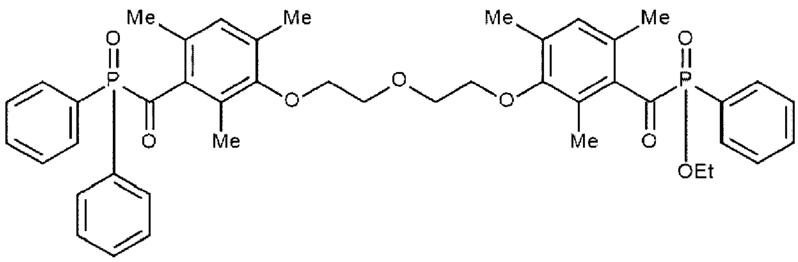

,

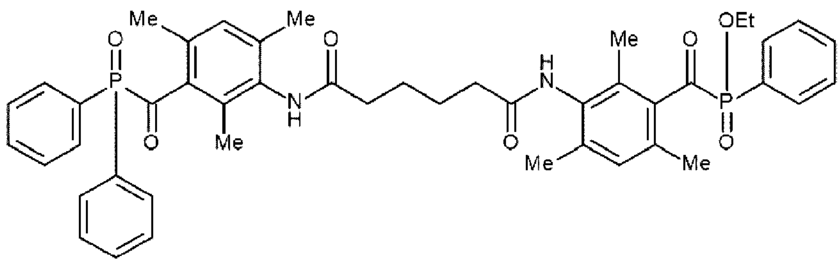

,

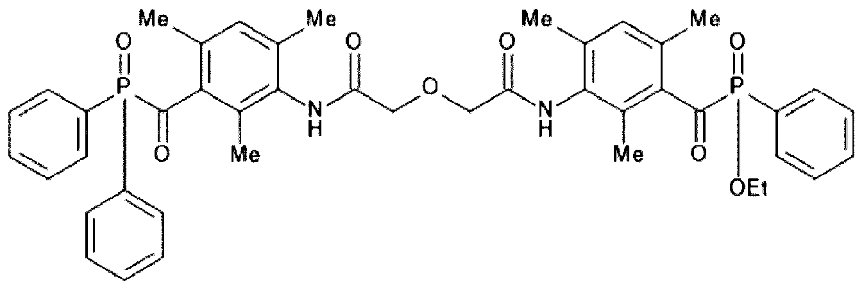

,

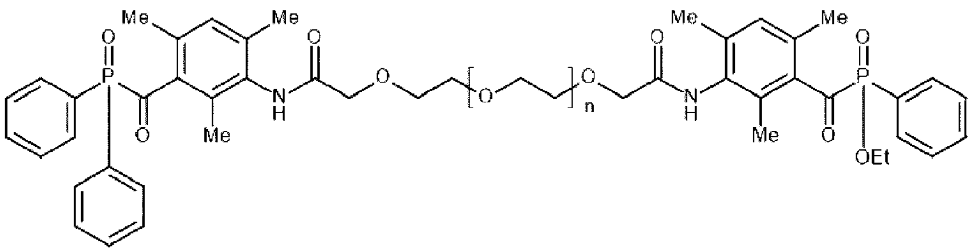

N = 2 durchschnittlich,

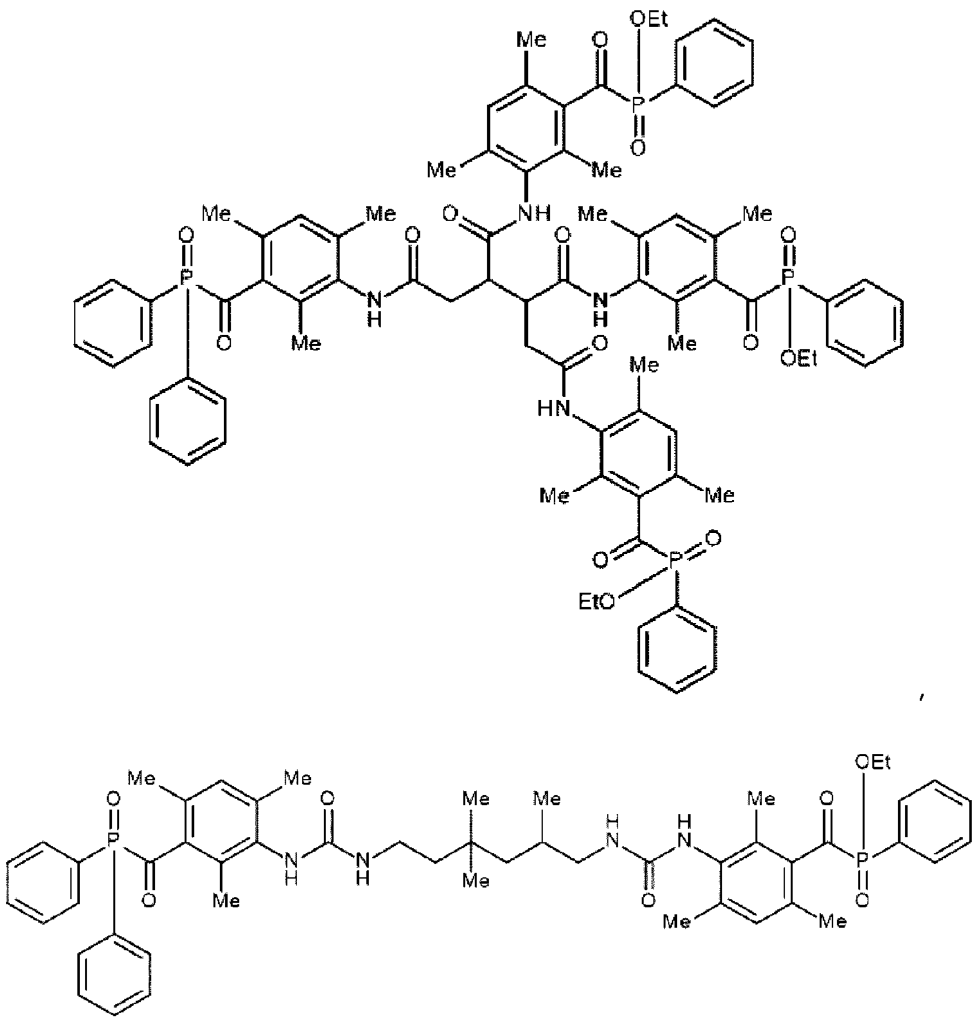

,

,

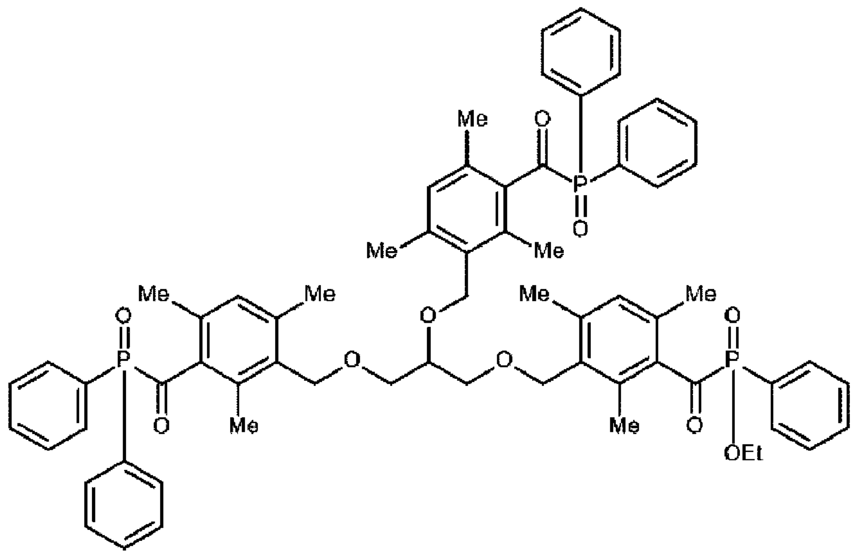

,

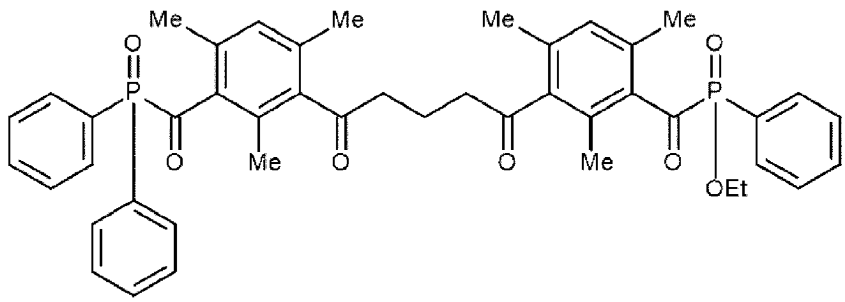

,

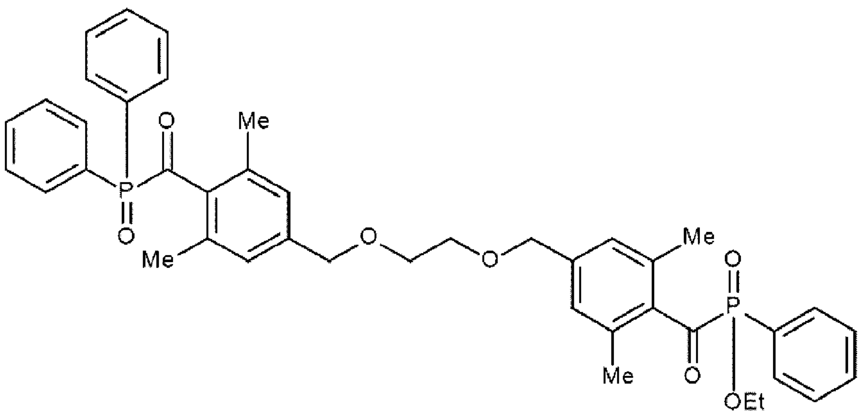

,

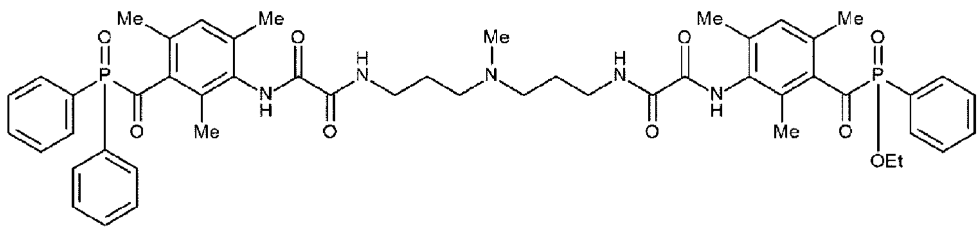

,

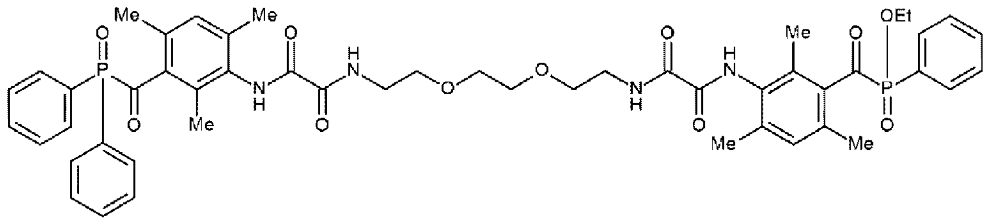

,

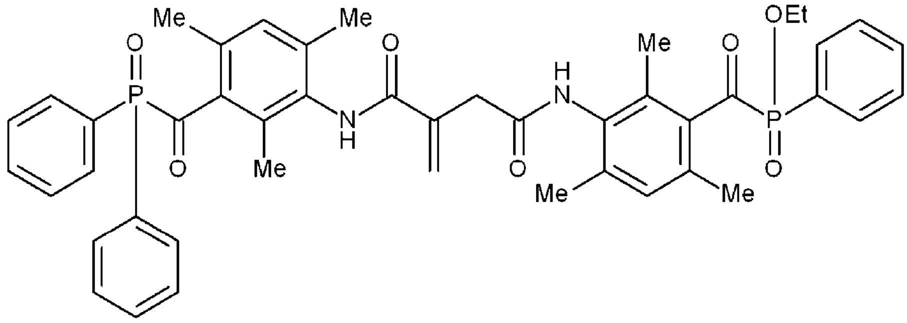

,

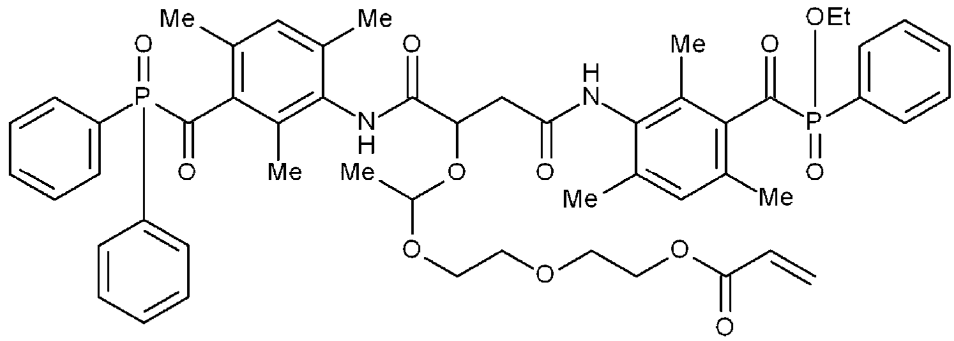

,

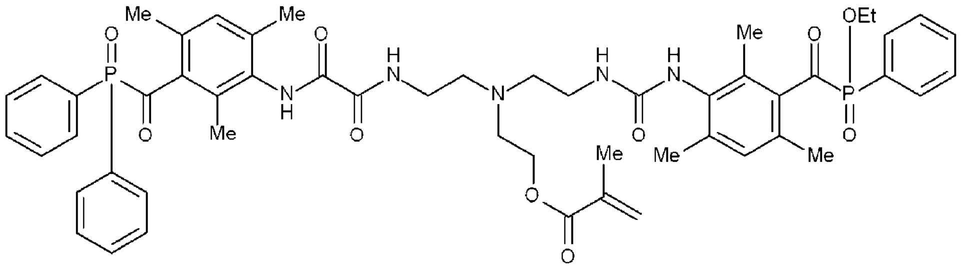

,

und

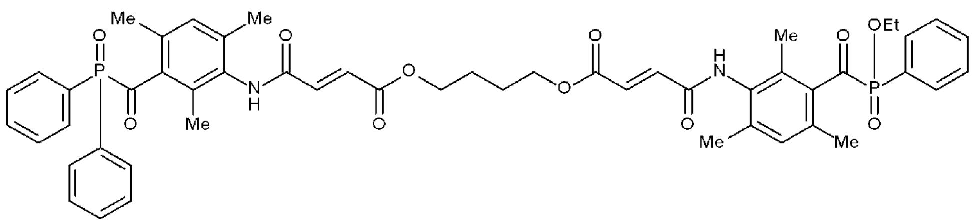

.

9. Ein Gemisch von Fotoinitiatoren, das mindestens einen Fotoinitiator nach Anspruch 4 oder nach Anspruch 6 enthält, wobei der Fotoinitiator gemäß Formel (1), in der x und y die ganze Zahl 1 bedeuten, Teil des Gemisches ist, das die Fotoinitiatoren gemäß Formel (1-a), Formel (1-b) und Formel (1-c) enthält, wobei die Gruppen A, B und L wie für den

Fotoinitiator gemäß Formel (1) definiert sind, wobei Formel (1-a) A-L-B ist, Formel (1-b) A-L-A ist und Formel (1-c) B-L-B ist, und wobei das Gemisch zwischen 20 mol-% und 80 mol-% des Fotoinitiators gemäß Formel (1-a) enthält, oder wobei der Fotoinitiator gemäß Formel (2), in der x und y die ganze Zahl 1 bedeuten, Teil eines Gemisches von Fotoinitiatoren ist, das die Fotoinitiatoren gemäß Formel (2a), Formel (2-b) und Formel (2-c) enthält, wobei die Gruppen A' A-NH-C(=O)-$(X)_n$-bedeuten, die Gruppen B' B-NH-C(=O)-$(Y)_m$- bedeuten und L1 wie für den Fotoinitiator gemäß Formel (2) definiert ist, wobei Formel (2-a) A'-L1-B' ist, Formel (2-b) A'-L1-A' ist und Formel (2-c) B'-L1-B' ist, und wobei das Gemisch zwischen 20 mol-% und 80 mol-% des Fotoinitiators gemäß Formel (2-a) enthält.

**10.** Eine fotohärtbare Zusammensetzung, die einen Fotoinitiator nach einem der Ansprüche 1 bis 8 und eine durch freie Radikale polymerisierbare Verbindung als Hauptkomponenten enthält.

**11.** Die fotohärtbare Zusammensetzung nach Anspruch 10, die ein Gemisch von Fotoinitiatoren nach Anspruch 9 enthält.

**12.** Eine fotohärtbare Tinte, die ein Pigment und die fotohärtbare Zusammensetzung nach Anspruch 10 oder Anspruch 11 enthält.

**13.** Ein gehärtetes Produkt, wobei das gehärtete Produkt durch UV-LED-Härtung der fotohärtbaren Zusammensetzung nach einem der Ansprüche 10 bis 12 gebildet wird.

**14.** Ein Verfahren zur Herstellung eines Gemisches von Fotoinitiatoren, das einen Fotoinitiator nach einem der Ansprüche 1 bis 8 enthält, umfassend die folgenden Schritte:

a) Vermischen von 2 Monoacylphosphinoxidverbindungen, die eine unterschiedliche chemische Struktur im Phosphinoxidteil aufweisen, und wobei jede Verbindung eine an den Acylteil gebundene primäre Aminogruppe oder eine an den Acylteil gebundene Gruppe gemäß Formel (M-1) in einem Molverhältnis von 3:1 bis 1:3 enthält, und
b) Reagierenlassen der 2 Monoacylphosphinoxidverbindungen mit einer Verbindung, die die 2 Monoacylphosphinoxidverbindungen über die primäre Aminogruppe oder die Gruppe gemäß Formel (M-1) verbindet, wobei die Gruppe gemäß Formel (M-1) folgende Gruppe ist:

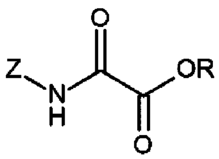

Formel (M-1),

in der Z ein Kohlenstoffatom eines aromatischen Ringes im Acylteil bedeutet und R eine $C_1$-$C_6$-Alkylgruppe, bevorzugt eine Ethylgruppe, bedeutet.

**15.** Verwendung eines Fotoinitiators nach einem der Ansprüche 1 bis 8, um die Oberflächenhärtung einer fotohärtbaren Zusammensetzung zu verbessern und/oder den Geruch eines gehärteten Produkts einer fotohärtbaren Zusammensetzung zu verringern.

## Revendications

**1.** Photoinitiateur contenant 2 à 6 groupements d'oxyde de monoacylphosphine, **caractérisé en ce que** les groupements d'oxyde de monoacylphosphine sont liés entre eux par leur groupe acyle et qu'au moins 2 groupements d'oxyde de monoacylphosphine ont une structure chimique différente dans la partie d'oxyde de phosphine.

**2.** Photoinitiateur selon la revendication 1, **caractérisé en ce que** le photoinitiateur contient 2 ou 3 groupements d'oxyde de monoacylphosphine.

**3.** Photoinitiateur selon la revendication 1 ou 2, **caractérisé en ce que** le groupe de liaison entre les groupements d'oxyde de monoacylphosphine comprend un groupe polymérisable par radicaux libres.

**4.** Photoinitiateur selon la revendication 1 ou 2 ayant une structure répondant à la Formule (1):

$[A]_y - L - [B]_x$ Formule (1),

où

x et y représentent, indépendamment l'un de l'autre, un nombre entier de 1 à 3,
L représente un groupe de liaison (x+y)-valent comprenant un maximum de 25 atomes de carbone,
A représente un oxyde d'acylphosphine répondant à la Formule (1-1):

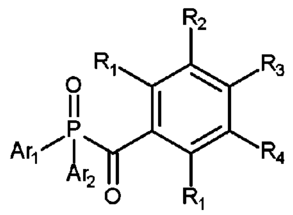

Formule (1-1),

où

$Ar_1$ et $Ar_2$ représentent, indépendamment l'un de l'autre, un groupe aryle ou hétéroaryle substitué ou non substitué,
$R_1$ est choisi parmi le groupe composé d'un groupe alkyle substitué ou non substitué, d'un groupe aryle substitué ou non substitué et d'un groupe alcoxy substitué ou non substitué, et $R_2$, $R_3$ et $R_4$ sont choisis, indépendamment l'un de l'autre, parmi le groupe composé du site de liaison à L ou d'un substituant choisi parmi le groupe composé d'hydrogène, d'un groupe alkyle substitué ou non substitué, d'un groupe alcényle substitué ou non substitué, d'un groupe alcynyle substitué ou non substitué, d'un groupe alcoxy substitué ou non substitué et d'un groupe aryle ou hétéroaryle substitué ou non substitué,

B représente un groupement d'oxyde d'acylphosphine répondant à la Formule (1-2):

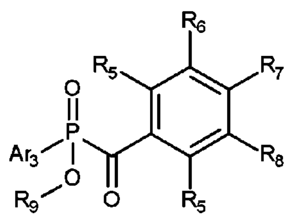

Formule (1-2),

où

$Ar_3$ représente un groupe aryle ou hétéroaryle substitué ou non substitué,
$R_5$ est choisi parmi le groupe composé d'un groupe alkyle substitué ou non substitué, d'un groupe aryle substitué ou non substitué et d'un groupe alcoxy substitué ou non substitué, $R_6$, $R_7$ et $R_8$ sont choisis, indépendamment l'un de l'autre, parmi le groupe composé du site de liaison à L ou d'un substituant choisi parmi le groupe composé d'hydrogène, d'un groupe alkyle substitué ou non substitué, d'un groupe alcényle substitué ou non substitué, d'un groupe alcynyle substitué ou non substitué, d'un groupe alcoxy substitué ou non substitué et d'un groupe aryle ou hétéroaryle substitué ou non substitué, et
$R_9$ représente un groupe alkyle substitué ou non substitué, un groupe alcényle substitué ou non substitué, un groupe alcynyle substitué ou non substitué et un groupe aryle ou hétéroaryle substitué ou non substitué.

**5.** Photoinitiateur selon la revendication 4, **caractérisé en ce que** le rapport de poids moléculaire entre, d'une part, A et B et, d'autre part, L satisfait l'équation suivante: $(x * Mw(A) + y * Mw(B))/ Mw(L) \geq 1,5$.

**6.** Photoinitiateur selon la revendication 1 ou 2 ayant une structure répondant à la Formule (2):

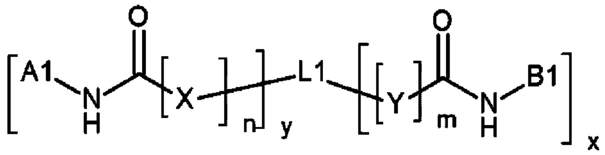

Formule (2),

où

n et m représentent, indépendamment l'un de l'autre, 0 ou 1,
x et y représentent, indépendamment l'un de l'autre, un nombre entier de 1 à 3,
L1 représente un groupe de liaison (x+y)-valent comprenant un maximum de 25 atomes de carbone,
X et Y représentent, indépendamment l'un de l'autre, O ou NH,
A1 représente un groupement d'oxyde d'acylphosphine répondant à la Formule (2-1):

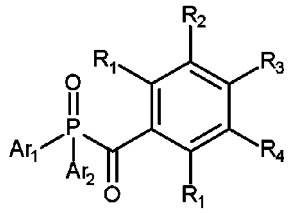

Formule (2-1),

où
$Ar_1$ et $Ar_2$ représentent, indépendamment l'un de l'autre, un groupe aryle ou hétéroaryle substitué ou non substitué, $R_1$ est choisi parmi le groupe composé d'un groupe alkyle substitué ou non substitué, d'un groupe aryle substitué ou non substitué et d'un groupe alcoxy substitué ou non substitué, $R_2$, $R_3$ et $R_4$ sont choisis, indépendamment l'un de l'autre, parmi le groupe composé du site de liaison à N ou d'un substituant choisi parmi le groupe composé d'hydrogène, d'un groupe alkyle substitué ou non substitué, d'un groupe alcényle substitué ou non substitué, d'un groupe alcynyle substitué ou non substitué, d'un groupe alcoxy substitué ou non substitué et d'un groupe aryle ou hétéroaryle substitué ou non substitué,
B1 représente un groupement d'oxyde d'acylphosphine répondant à la Formule (2-2):

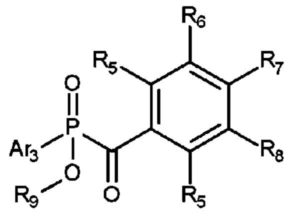

Formule (2-2),

où $Ar_3$ représente un groupe aryle ou hétéroaryle substitué ou non substitué, $R_5$ est choisi parmi le groupe composé d'un groupe alkyle substitué ou non substitué, d'un groupe aryle substitué ou non substitué et d'un groupe alcoxy substitué ou non substitué, $R_6$, $R_7$ et $R_8$ sont choisis, indépendamment l'un de l'autre, parmi le groupe composé du site de liaison à N ou d'un substituant choisi parmi le groupe composé d'hydrogène, d'un groupe alkyle substitué ou non substitué, d'un groupe alcényle substitué ou non substitué, d'un groupe alcynyle substitué ou non substitué, d'un groupe alcoxy substitué ou non substitué et d'un groupe aryle ou hétéroaryle substitué ou non substitué, $R_9$ représente un groupe alkyle substitué ou non substitué, un groupe alcényle substitué ou non substitué, un groupe alcynyle substitué ou non substitué et un groupe aryle ou hétéroaryle substitué ou non substitué.

7. Photoinitiateur selon l'une quelconque des revendications 4 à 6, **caractérisé en ce que** le groupe de liaison L ou L1 comprend au moins une fonction éther ou un groupe amino tertiaire.

8. Photoinitiateur selon la revendication 1, **caractérisé en ce que** le photoinitiateur est choisi parmi le groupe composé de:

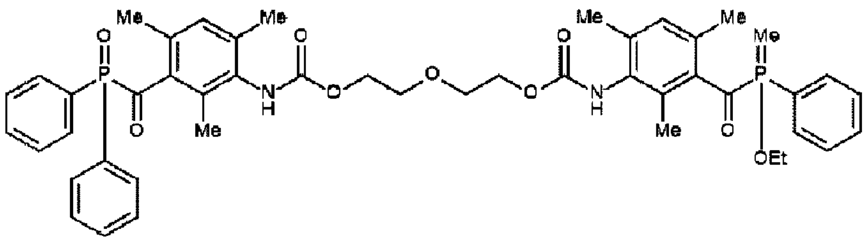

,

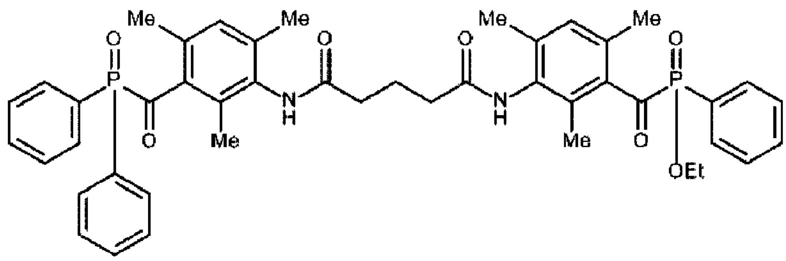

,

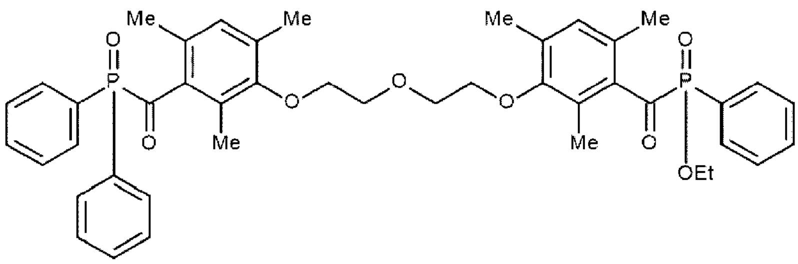

,

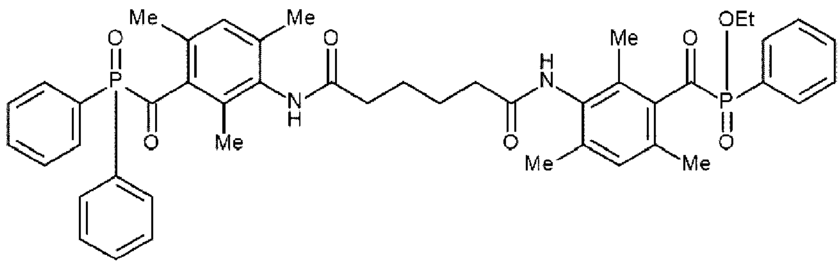

,

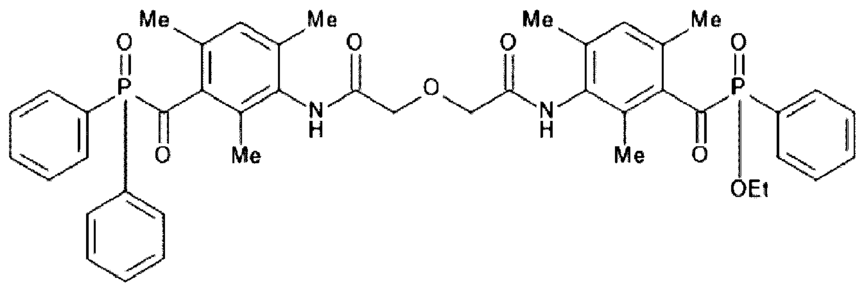

,

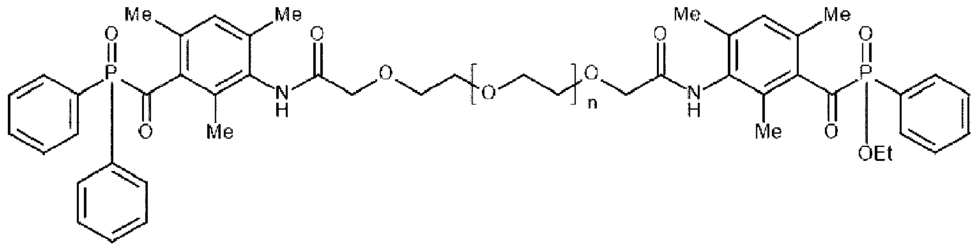

N = 2 en moyenne,

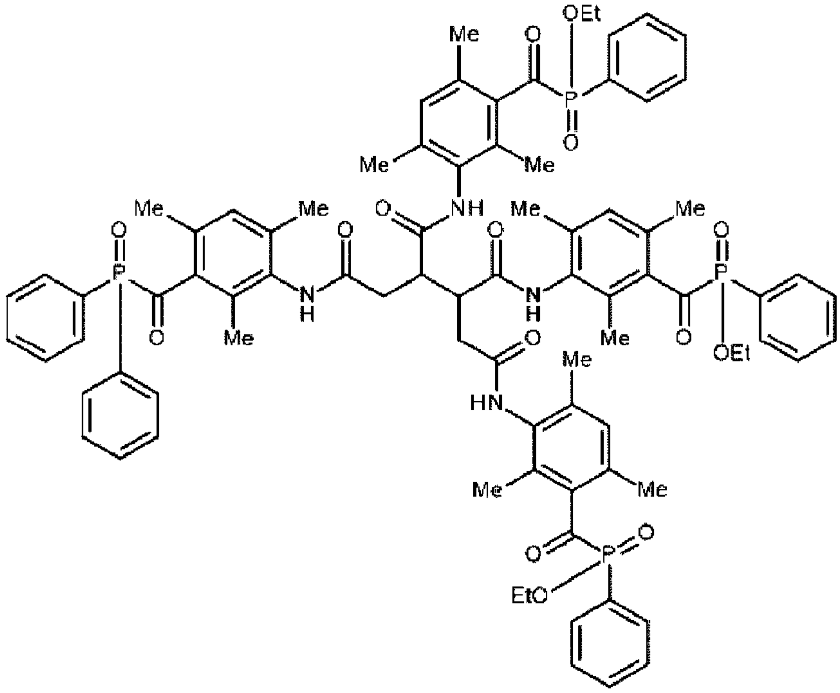

,

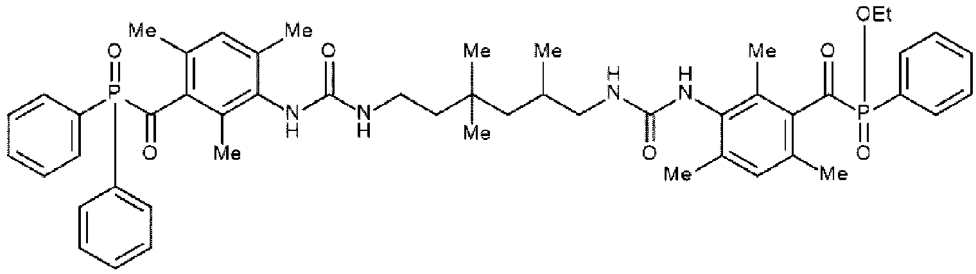

,

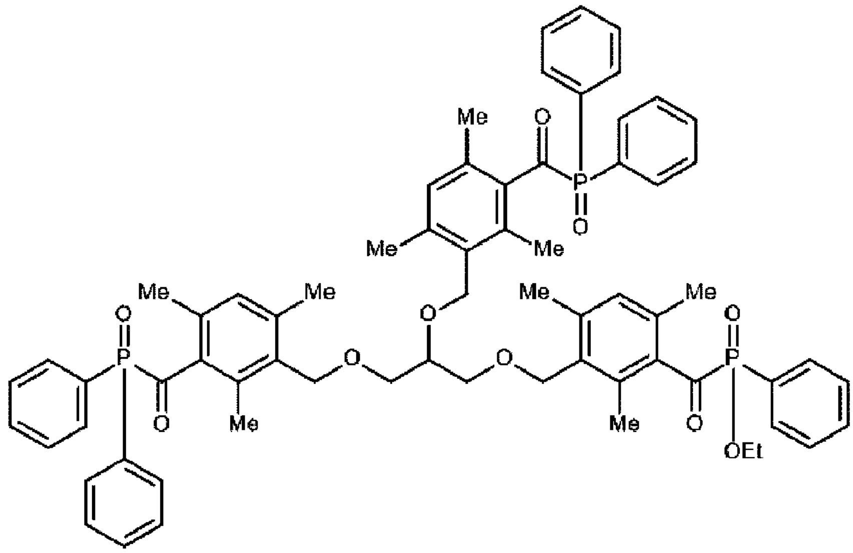

,

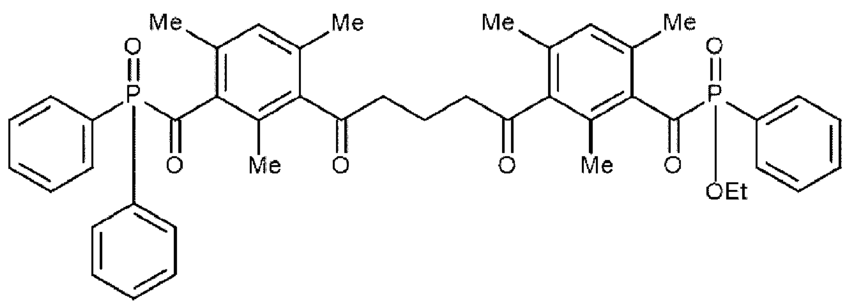

,

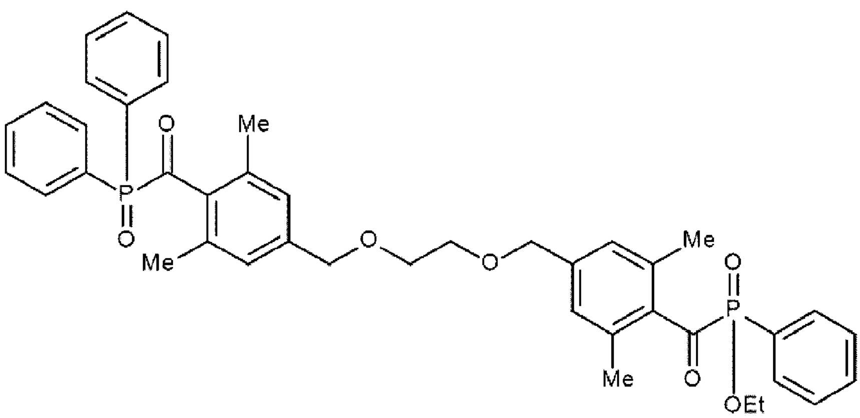

,

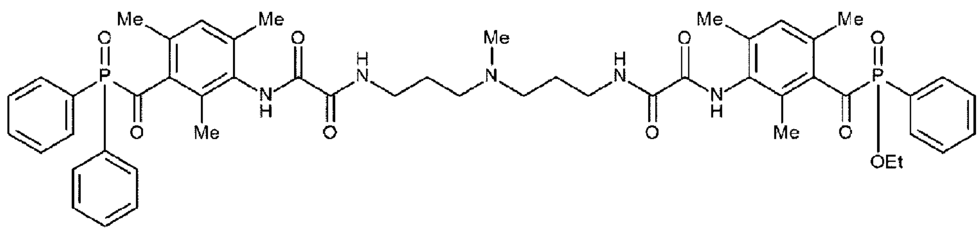

,

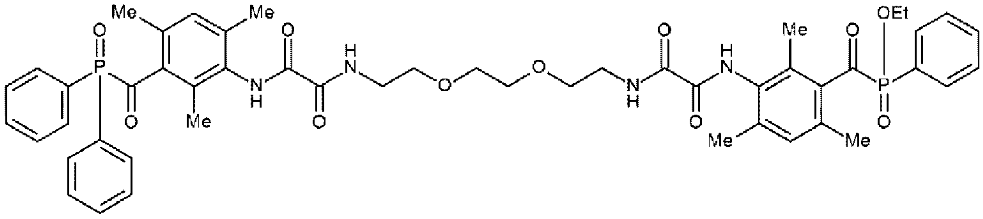

,

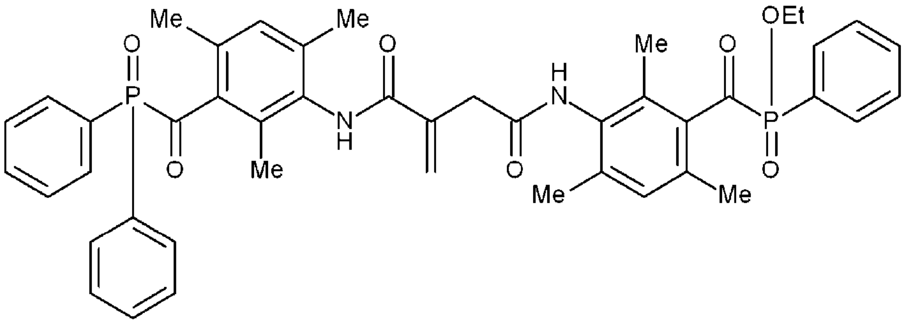

,

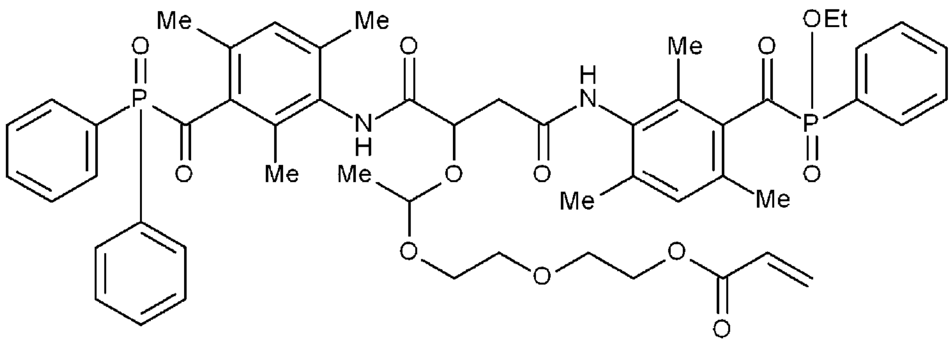

,

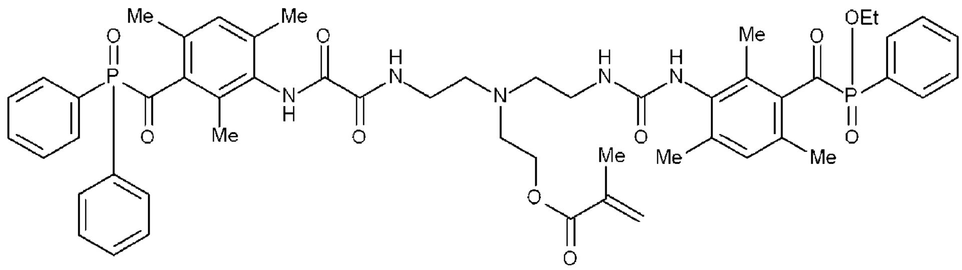

,

et

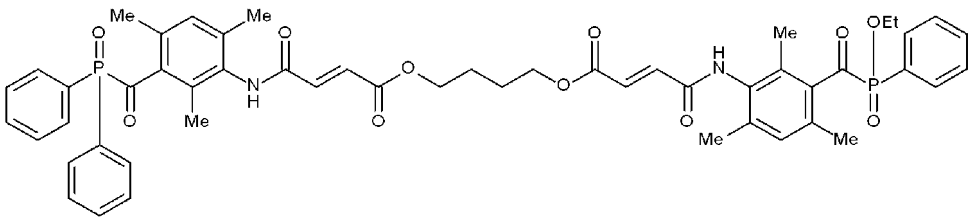

.

9. Mélange de photoinitiateurs contenant au moins un photoinitiateur selon la revendication 4 ou la revendication 6, **caractérisé en ce que** le photoinitiateur répondant à la Formule (1), où x et y représentent le nombre entier 1, fait partie du mélange contenant les photoinitiateurs répondant à la Formule (1-a), la Formule (1-b) et la Formule (1-c), où

les groupes A, B et L sont tels que définis pour le photoinitiateur répondant à la Formule (1), où la Formule (1-a) représente A-L-B, la Formule (1-b) représente A-L-A et la Formule (1-c) représente B-L-B, et **caractérisé en ce que** le mélange contient entre 20 moles % et 80 moles % du photoinitiateur répondant à la Formule (1-a), ou **caractérisé en ce que** le photoinitiateur répondant à la Formule (2), où x et y représentent le nombre entier 1, fait partie d'un mélange de photoinitiateurs contenant les photoinitiateurs répondant à la Formule (2a), la Formule (2-b) et la Formule (2-c), où les groupes A' représentent A-NH-C(=O)-$(X)_n$-, les groupes B' représentent B-NH-C(=O)-$(Y)_m$- et L1 est tel que défini pour le photoinitiateur répondant à la Formule (2), où la Formule (2-a) représente A'-L1-B', la Formule (2-b) représente A'-L1-A' et la Formule (2-c) représente B'-L1-B', et **caractérisé en ce que** le mélange contient entre 20 moles % et 80 moles % du photoinitiateur répondant à la Formule (2-a).

**10.** Composition photodurcissable contenant un photoinitiateur selon l'une quelconque des revendications 1 à 8 et un composé polymérisable par radicaux libres comme composants principaux.

**11.** Composition photodurcissable selon la revendication 10 contenant un mélange de photoinitiateurs selon la revendication 9.

**12.** Encre photodurcissable contenant un pigment et la composition photodurcissable selon la revendication 10 ou la revendication 11.

**13.** Produit durci, **caractérisé en ce que** le produit durci est formé en effectuant un durcissement par diodes LED UV de la composition photodurcissable selon l'une quelconque des revendications 10 à 12.

**14.** Procédé pour la préparation d'un mélange de photoinitiateurs contenant un photoinitiateur selon l'une quelconque des revendications 1 à 8, ledit procédé comprenant les étapes consistant à:

a) mélanger 2 composés d'oxyde de monoacylphosphine ayant une structure chimique différente dans la partie d'oxyde de phosphine et où chaque composé contient un groupe amino primaire lié à partie d'acyle ou un groupe répondant à la Formule (M-1) lié à partie d'acyle dans un rapport molaire de 3:1 à 1:3, et

b) faire réagir les 2 composés d'oxyde de monoacylphosphine avec un composé assurant la liaison des 2 composés d'oxyde de monoacylphosphine par le groupe amino primaire ou le groupe répondant à la Formule (M-1),

**caractérisé en ce que** le groupe répondant à la Formule (M-1) est représenté par:

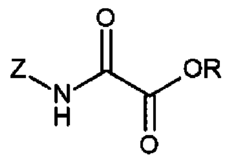

Formule (M-1),

où Z représente un atome de carbone d'un noyau aromatique dans la partie d'acyle et R représente un groupe alkyle en $C_1$-$C_6$, de préférence un groupe éthyle.

**15.** Utilisation d'un photoinitiateur selon l'une quelconque des revendications 1 à 8 afin d'améliorer le durcissement superficiel d'une composition photodurcissable et/ou de réduire l'odeur d'un produit durci d'une composition photodurcissable.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2014051026 A
- WO 2014129213 A
- WO 2019243039 A
- WO 2022106099 A
- WO 2017191043 A
- WO 2022106100 A


### Non-patent literature cited in the description


- Polymer Handbook. Wiley-Interscience, 1999, vol. 1,2
- **CRIVELLO, J.V. et al.** Photoinitiators for Free Radical Cationic. John Wiley and Sons Ltd, 1998, vol. III, 287-294